(19) Europäisches Patentamt
European Patent Office
Office européen des brevets

(11) EP 4 596 887 A1

(12) EUROPEAN PATENT APPLICATION
published in accordance with Art. 153(4) EPC

(43) Date of publication:
06.08.2025 Bulletin 2025/32

(51) International Patent Classification (IPC):
F04D 27/00 (2006.01)

(21) Application number: 23871451.3

(22) Date of filing: 02.08.2023

(52) Cooperative Patent Classification (CPC):
H05K 7/20209; F04D 27/00; H05K 7/20

(86) International application number:
PCT/JP2023/028274

(87) International publication number:
WO 2024/070209 (04.04.2024 Gazette 2024/14)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 30.09.2022 JP 2022158234

(71) Applicant: DAIKIN INDUSTRIES, LTD.
Osaka-shi, Osaka 530-0001 (JP)

(72) Inventors:
• YOKOYAMA, Takahiro
Osaka-shi, Osaka 530-0001 (JP)
• ARAKI, Takeshi
Osaka-shi, Osaka 530-0001 (JP)
• MIURA, Shimpei
Osaka-shi, Osaka 530-0001 (JP)

(74) Representative: Hoffmann Eitle
Patent- und Rechtsanwälte PartmbB
Arabellastraße 30
81925 München (DE)

(54) CONTROL DEVICE AND PROGRAM

(57) A control device including a control unit configured to control a fan system including a fan and a motor for driving the fan is disclosed. The control unit includes a fan characteristic storage unit configured to store correlated information correlated to a fan characteristic, the fan characteristic being a characteristic of the fan. The control unit controls the fan system based on the correlated information. The control unit includes a correction unit configured to correct the correlated information to correspond to changes in the fan characteristic occurring as a function of deformation over time of the fan.

FIG.1

EP 4 596 887 A1

## Description

Technical Field

The present invention relates to a control device and a program.

Background Art

Patent Literature 1 discloses an electronic device configured to calculate a deviation value from a normal boundary of a relationship between a power index associated with a driving power for a fan and a measured rotation speed of the fan and to detect clogging in an air duct through which the fan takes in air outside a case and sends the air to a radiator. Patent Literature 1 discloses correcting the calculated deviation value in accordance with aging of performance of the fan to compensate for deterioration of a clogging detection capability caused by the aging, which is due to, e.g., degradation of lubricant used for the bearing of the fan and dust adhering near the fan rotation unit.

Citation List

Patent Literature

Patent Literature 1: Japanese Patent No. 5175622

Summary of Invention

Technical Problem

In controlling a fan system including a fan driven by a motor, the status of the fan system may be estimated. In such cases, the status of the fan system is estimated based on information obtained from, e.g., sensors and other devices, as well as information about a characteristic of the fan that is already known. However, any changes in the fan characteristic due to deformation over time of the fan itself may cause the results of estimation to deviate from the actual conditions, leading to reduced accuracy in controlling the fan system.

An object of the present disclosure is to control the fan system by taking into account changes in a fan characteristic.

Solution to Problem

An aspect of the present disclosure provides a control device including a control unit configured to control a fan system including a fan and a motor for driving the fan. The control unit includes a fan characteristic storage unit configured to store correlated information correlated to a fan characteristic, the fan characteristic being a characteristic of the fan. The control unit controls the fan system based on the correlated information. The control unit includes a correction unit configured to correct the correlated information to correspond to changes in the fan characteristic occurring as a function of deformation over time of the fan. According to this aspect, the fan system can be controlled by taking into account changes in the fan characteristic.

The control unit may acquire a value of at least one of an ambient temperature of the fan and a rotation speed of the fan, and correct the correlated information based on the acquired value. With this feature, the fan system can be controlled by taking into account changes in the fan characteristic based on at least one of the ambient temperature of the fan and the rotation speed of the fan.

In cases where the control unit controls an airflow of the fan based on a relationship between at least one of driving power for the motor, the rotation speed of the fan, and a static pressure of the fan and the airflow of the fan, the fan characteristic may represent the relationship. With this feature, the airflow of the fan can be controlled by taking into account changes in the fan characteristic based on at least one of the driving power for the motor, the rotation speed of the fan, and the static pressure of the fan.

In cases where the control unit acquires a physical quantity correlated to a static pressure of the fan and monitors the static pressure of the fan based on a relationship between the physical quantity and the static pressure of the fan, the fan characteristic may represent the relationship. With this feature, the static pressure of the fan can be monitored by taking into account changes in the fan characteristic based on a physical quantity correlated to the static pressure of the fan.

In cases where the control unit acquires a physical quantity correlated to an abnormality in the fan system and monitors the abnormality in the fan system based on a relationship between the physical quantity and the abnormality in the fan system, the fan characteristic may represent the relationship. With this feature, an abnormality in the fan system can be monitored by taking into account changes in the fan characteristic based on a physical quantity correlated to the abnormality in the fan system.

The abnormality in the fan system may be vibration or noise of the fan system. In this case, the abnormality in the fan system, which is vibration or noise of the fan system, can be monitored by taking into account changes in the fan characteristic.

In cases where the control unit acquires a physical quantity correlated to refrigeration efficiency of a refrigeration apparatus including the fan system and predicts the refrigeration efficiency of the refrigeration apparatus based on a relationship between the physical quantity and the refrigeration efficiency of the refrigeration apparatus, the fan characteristic may represent the relationship. With this feature, the refrigeration efficiency of the refrigeration apparatus can be predicted by taking into account changes in the fan characteristic based on a physical quantity correlated to the refrigeration efficiency of the refrigeration apparatus.

In cases where the control unit acquires a physical quantity correlated to cooling capacity of a refrigeration apparatus including the fan system and predicts the cooling capacity of the refrigeration apparatus based on a relationship between the physical quantity and the cooling capacity of the refrigeration apparatus, the fan characteristic may represent the relationship. With this feature, the cooling capacity of the refrigeration apparatus can be predicted by taking into account changes in the fan characteristic based on a physical quantity correlated to the cooling capacity of the refrigeration apparatus.

Another aspect of the present disclosure provides a control device including a control unit configured to control a fan system including a fan and a motor for driving the fan. The control unit acquires a physical quantity correlated to an ambient temperature of the fan. The control unit controls the fan system based on a history of the acquired physical quantity. According to this aspect, the fan system can be controlled by taking into account changes in the fan characteristic based on the history of a physical quantity correlated to the ambient temperature of the fan.

The control unit may estimate the ambient temperature of the fan of a refrigeration apparatus including the fan system, a flow path through which a fluid is delivered by the fan, and a heat exchanger installed in the flow path, based on at least one of a temperature around the fan and a temperature of the heat exchanger. With this feature, the ambient temperature of the fan can be acquired without actually measuring it.

Still another aspect of the present disclosure provides a computer program including instructions that, when executed by a computer configured to control a fan system including a fan and a motor for driving the fan, cause the computer to execute functions of: storing correlated information correlated to a fan characteristic, the fan characteristic being a characteristic of the fan; controlling the fan system based on the correlated information; and implementing a correction unit configured to correct the correlated information to correspond to changes in the fan characteristic occurring as a function of deformation over time of the fan. According to this aspect, the fan system can be controlled by taking into account changes in the fan characteristic.

Brief Description of Drawings

FIG. 1 shows a schematic configuration of a control system of a first embodiment.
FIG. 2 shows an example hardware configuration of devices used in the first embodiment.
FIG. 3 shows an example functional configuration of an oil cooling device according to the first embodiment.
FIGS. 4A and 4B show fan characteristics according to the present embodiment, where FIG. 4A shows a differential pressure characteristic, and FIG. 4B shows a power characteristic.
FIG. 5 shows a relationship between pressure loss across a filter and the degree of fan deceleration.
FIG. 6 shows an example functional configuration of a control device according to the first embodiment.
FIG. 7 shows deformation over time of the fan.
FIG. 8 shows a relationship between the history of the fan temperature and a fan deformation index.
FIGS. 9A and 9B show a relationship between the history of the fan or motor rotation speed and the fan deformation index, where FIG. 9A shows the case where the fan is rotated at 45 [°C], and FIG. 9B shows the case where the fan is rotated at 60 [°C].
FIG. 10 is a flowchart showing a process flow for controlling the airflow of the fan.
FIG. 11 shows a relationship between the rotation speed of the fan and the driving power for the motor.
FIG. 12 is a flowchart showing a process flow for determining a clogging of the filter.
FIG. 13 shows a relationship between the fan deceleration time and the pressure loss index across the filter when the rotation speed immediately before cutting off the driving force for the fan is a predetermined rotation speed.
FIG. 14 shows a schematic configuration of a control system according to a third embodiment.
FIG. 15 is a flowchart showing a process flow for controlling the static pressure of the fan.
FIG. 16 is a flowchart showing a process flow for suppressing vibration caused by the fan.

FIGS. 17A and 17B show a relationship between the vibration characteristic of the fan and the vibration area, where FIG. 17A shows the case of an initial fan that has not been deformed over time, and FIG. 17B shows the case of a fan that has been deformed over time.

FIGS. 18A and 18B show the results of a frequency analysis of phase currents supplied to the motor, where FIG. 18A shows each order component when the fan and the motor are in balance, and FIG. 18B shows each order component when the fan and the motor are out of balance.

FIG. 19 shows the intensity difference between spectra.

FIG. 20 is a flowchart showing a process flow for controlling the refrigeration efficiency by the fan.

Description of Embodiments

Exemplary embodiments are described below with reference to the appended drawings. The dimensions in the drawings are modified from the actual scales as appropriate for the sake of clarity and brevity and are not to relative scale. In the drawings, like reference numerals designate like or corresponding elements.

First Embodiment

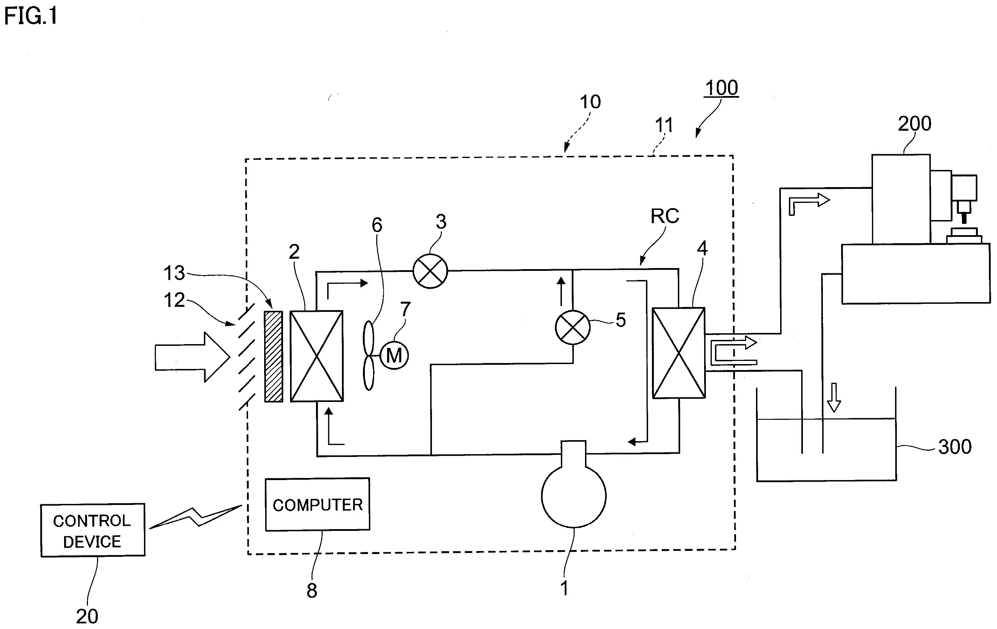

FIG. 1 shows a schematic configuration of a control system 100 of a first embodiment.

The control system 100 is a system for controlling a device including a fan 6 and a motor 7 for driving the fan. The control system 100 includes an oil cooling device 10 and a control device 20 for controlling the oil cooling device 10. In the control system 100, the oil cooling device 10 and the control device 20 can communicate with each other via communication lines. In the present embodiment, the communication lines are not limited and may be any communication lines that enable communication between the devices. For example, the devices are connected via a network such as the Internet.

The oil cooling device 10, which is an example of the fan system, includes the fan and the motor for driving the fan. The oil cooling device 10 cools oil. For example, the oil cooling device 10 is a device that allows hydraulic oil, lubricating oil, and cutting fluid (hereinafter referred to as "oil") for a machine tool 200 to circulate therein via an oil tank 300 to cool the oil. Examples of the machine tool 200 include industrial machinery such as molding machines and press machines.

The oil cooling device 10 includes a compressor 1, a condenser 2, a decompression mechanism 3, an evaporator 4, the fan 6, the motor 7, and a computer 8. The compressor 1, the condenser 2, the decompression mechanism 3, and the evaporator 4 are connected in an annular manner with communication pipes for oil-cooling refrigerant, thereby forming a refrigerant circuit RC with a bypass mechanism 5.

The refrigerant circuit RC, the fan 6, the motor 7, and the computer 8 are housed in an enclosure 11. The enclosure 11 has an air inlet 12 on its side where the condenser 2 is located, and a filter 13 is attached to the air inlet 12.

The refrigerant circuit RC allows the oil-cooling refrigerant to circulate therein to cool the oil.

The refrigerant circuit RC is connected with the communication pipes, which are liquid communication pipes or gas communication pipes depending on the state of the refrigerant.

The compressor 1 compresses the gas refrigerant in an evaporated state. Specifically, the compressor 1 compresses the gas refrigerant flowing in from the communication pipe leading from the evaporator 4 and discharges the compressed refrigerant into the communication pipe leading to the condenser 2.

The gas refrigerant discharged into the communication pipe leading to the condenser 2 has an increased temperature and pressure due to compression, turning into a high-temperature and high-pressure gas refrigerant relative to the gas refrigerant that flows in from the communication pipe leading from the evaporator 4.

The condenser 2, which is an example of the heat exchanger, condenses the compressed gas refrigerant. Specifically, the condenser 2 cools the high-temperature and high-pressure gas refrigerant flowing in from the communication pipe leading from the compressor 1 and discharges the cooled refrigerant into the communication pipe leading to the decompression mechanism 3.

The refrigerant discharged into the communication pipe leading to the decompression mechanism 3 has changed its state due to condensation by cooling, turning into a high-temperature and high-pressure liquid refrigerant.

The decompression mechanism 3 decompresses the liquid refrigerant produced by condensing the gas refrigerant. Specifically, the decompression mechanism 3 adjusts the flow rate of the high-temperature and high-pressure liquid refrigerant flowing in from the communication pipe leading from the condenser 2 and discharges it into the communication pipe leading to the evaporator 4.

The liquid refrigerant discharged into the communication pipe leading to the evaporator 4 has a reduced temperature and pressure due to decompression by flow rate adjustment, turning into a low-temperature and low-pressure liquid refrigerant relative to the liquid refrigerant flowing in from the communication pipe leading from the condenser 2.

For example, the decompression mechanism 3 is an electric expansion valve with an adjustable opening.

The evaporator 4 evaporates the decompressed liquid refrigerant. Specifically, the evaporator 4 causes the low-temperature and low-pressure liquid refrigerant flowing in from the communication pipe leading from the decompression mechanism 3 to exchange heat with the ambient environment and discharges it into the communication pipe leading to the compressor 1.

The refrigerant discharged into the communication pipe leading to the compressor 1 has changed its state due to evaporation by heat exchange, turning into a low-temperature and low-pressure gas refrigerant.

In the above manner, the oil circulating via the oil tank 300 exchanges heat in the evaporator 4 with the refrigerant circulating through the refrigerant circuit RC and has its heat absorbed. In other words, the oil circulating via the oil tank 300 is cooled in the evaporator 4.

The bypass mechanism 5 adjusts the ability to cool the oil circulating via the oil tank 300. Specifically, the bypass mechanism 5 adjusts the flow rate of the high-temperature and high-pressure gas refrigerant supplied to the evaporator 4 and discharges the refrigerant into the communication pipe leading to the evaporator 4.

For example, the bypass mechanism 5 is an electric expansion valve with an adjustable opening.

The fan 6 creates a stream of air coming from outside the oil cooling device 10 into the oil cooling device 10 and passing through the condenser 2. Specifically, the fan 6 rotates such that air is drawn in from the air inlet 12 through the filter 13. The air filtered by the filter 13 is supplied to the condenser 2 and then discharged through an air outlet (not shown). The air flowing by the rotation of the fan 6 is an example of the fluid.

The fan 6 may be located at any position where it can create the above stream of air.

The fan 6 is made of a resin material.

The fan 6 is a rotating body driven by the motor 7. The fan 6 refers only to the rotating body and does not include the bearing of the fan.

The motor 7 is an electric motor that rotates the fan 6. In other words, the motor 7 is an electric motor that drives the fan 6. Specifically, the motor 7 has its axle connected to the rotation center portion of the fan 6 either directly or via gears, and drives the fan 6 once supplied with driving power.

The computer 8 processes information about the oil cooling device 10 to control the entire oil cooling device 10. Specifically, the computer 8 monitors the oil cooling device 10 for any abnormalities and controls the refrigerant circuit RC and the motor 7, based on the information about the oil cooling device 10.

The computer 8 is configured with, for example, one or more microcomputers. Alternatively, for example, some of the functions of the computer 8 may be implemented by a virtual server machine(s) in a so-called cloud environment.

Examples of the information about the oil cooling device 10 include the temperature and pressure of the refrigerant in the refrigerant circuit RC and the temperature of the components of the refrigerant circuit RC.

Other examples of the information about the oil cooling device 10 include the operating time of the motor 7, driving power for the motor 7, and temperature and rotation speed of the fan 6.

Still other examples of the information about the oil cooling device 10 include the degree to which the rotation speed of the fan 6 decelerates (hereinafter referred to as the "deceleration degree") after cutting off the driving force for the fan 6. The deceleration degree includes the time from when the supply of current to the motor 7 is stopped to when the rotation speed of the fan 6 decelerates to a stop (hereinafter referred to as the "deceleration time").

The stream of air created by the rotation of the fan 6 is delivered inside the enclosure 11. Specifically, the enclosure 11 defines a flow path, as an example of the flow path, through which the air flowing in from the air inlet 12 is delivered. The flow path may be defined by a duct or other structure disposed inside the enclosure 11.

In the present embodiment, the condenser 2 is installed in the flow path.

The filter 13 is installed in the enclosure 11. The filter has a path for air passage. For example, if the filter 13 is made of non-woven fabric, the interstices of the fibers of the non-woven fabric define a path for air passage.

If air containing fine particles is supplied through the filter 13, clogging of the filter 13 will occur. Such clogging of the filter 13 reduces the volume of air supplied to the condenser 2, which reduces the ability of the oil cooling device 10 to cool the oil.

In the present embodiment, the term "fine particle" refers to any airborne object, such as sand, dust, pollen, and oil mist.

The control device 20, which is an example of the control device, uses information (hereinafter referred to as "correlated information") correlated to a fan characteristic, which is a characteristic of the fan 6, to control the oil cooling device 10 including the fan system.

Specifically, the control device 20 acquires information about the oil cooling device 10 from the oil cooling device 10. The control device 20 provides correlated information to the oil cooling device 10 according to the information about the oil cooling device 10.

Examples of the control device 20 include computers, tablet information terminals, smartphones, and other information processing devices. The functions of the control device 20 may be distributed across multiple virtual server machines in a so-called cloud environment.

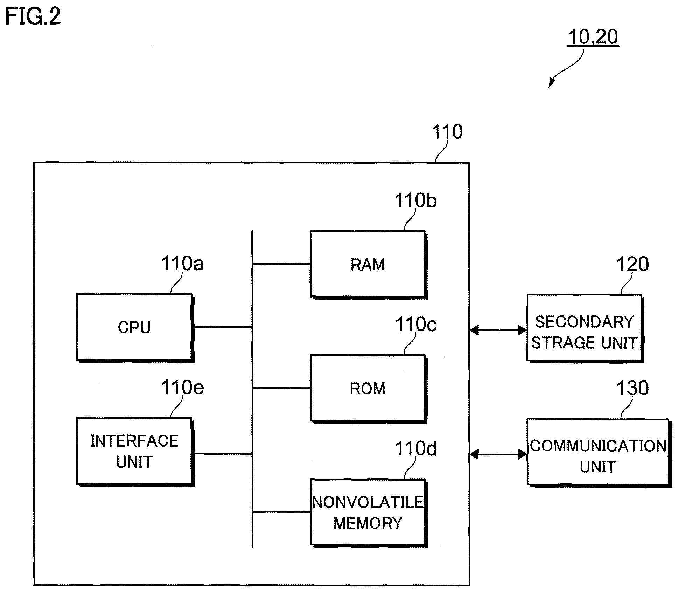

FIG. 2 shows an example hardware configuration of the devices used in the first embodiment, depicting an example hardware configuration of each of the computer 8 of the oil cooling device 10 and the control device 20.

Each device according to the present embodiment includes a control unit 110 to control the operation of the entire device. Each device may also include a secondary storage unit 120 for storing information about the oil cooling device 10 and a communication unit 130 to exchange information via communication lines (not shown). Each device may also include an input unit for receiving input operations from users, such as keys or a touch panel, and a display for displaying images and text to users, such as a liquid crystal display panel or an electro luminescence (EL) display panel.

The control unit 110 as an example of the control unit includes a CPU 110a, which is an example of the processor, to control the entire device, a RAM 110b used as a working memory for the CPU 110a, and a ROM 110c storing programs executed by the CPU 110a. The control unit 110 also includes a nonvolatile memory 110d that is rewritable and can retain data even after the power supply is turned off, and an interface unit 110e to control various units connected to the control unit 110, such as the communication unit 130.

For example, the nonvolatile memory 110d is an SRAM or flash memory backed up by a battery. Processes of the terminal devices of the present embodiment are executed as the control unit 110 reads the programs stored in the secondary storage unit 120.

For example, the secondary storage unit 120 is a hard disk drive (HDD) or semiconductor memory. The secondary storage unit 120 varies depending on the product type of the oil cooling device 10 and the control device 20.

The programs to be executed by the CPU 110a may be provided to the control unit 110 in the form of a computer-readable recording medium such as a magnetic recording medium (magnetic tape, magnetic disk, etc.), optical recording medium (optical disk, etc.), magnetooptical recording medium, or semiconductor memory. Alternatively, the programs to be executed by the CPU 110a may be provided to the control unit 110 over the Internet or other communication means.

The functional configuration of the oil cooling device 10 is now described.

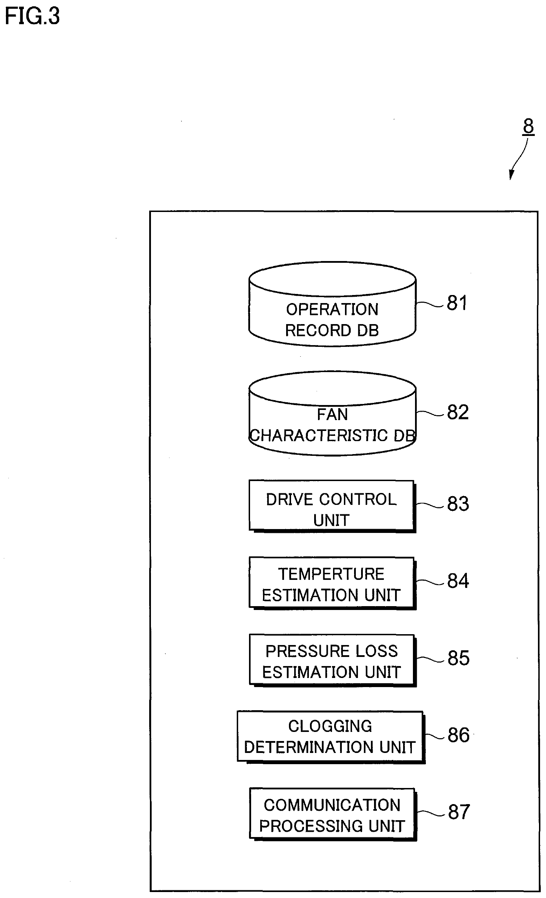

FIG. 3 shows an example functional configuration of the oil cooling device 10 according to the first embodiment.

Functions of the oil cooling device 10 shown in FIG. 3 are implemented mainly by the computer 8.

As shown in FIG. 3, the oil cooling device 10 includes an operation record database (DB) 81 and a fan characteristic DB 82. The oil cooling device 10 also includes a drive control unit 83, a temperature estimation unit 84, a pressure loss estimation unit 85, a clogging determination unit 86, and a communication processing unit 87.

The operation record DB81 stores values that are acquired while the oil cooling device 10 is in operation (hereinafter referred to as "acquired values"). The acquired values are values of a physical quantity(ies) that indicates the status of the oil cooling device 10 constituting the fan system.

In other words, the operation record DB 81 stores the history of acquired values from the oil cooling device 10.

The acquired values include not only measurements from sensors (not shown) but also values associated with the control by the drive control unit 83. The values associated with the control by the drive control unit 83 are not limited to those during the state controlled by the drive control unit 83, but may include those during the uncontrolled state according to the state controlled by the drive control unit 83.

Examples of the measurements from sensors include various temperatures such as the temperature of the condenser 2. Examples of the values associated with the control by the drive control unit 83 include the deceleration time Ti of the fan 6, the rotation speed N of the fan 6 or motor 7, and the operating time ti of the fan 6 or motor 7.

The deceleration time Ti of the fan 6 may be acquired by cutting off the supply of driving power to the motor 7 before the oil cooling device 10 is turned off. For example, the deceleration time Ti of the fan 6 may be acquired by driving the fan 6 and then cutting off the supply of driving power to the motor 7, during the time between when the oil cooling device 10 is turned on and when the refrigerant circuit RC is activated.

The fan characteristic DB 82, which is an example of the fan characteristic storage unit, stores correlated information correlated to a fan characteristic(s) of the fan 6. In other words, the fan characteristic DB 82 stores correlated information about the fan 6.

Correlated information includes, for example, an internal fan characteristic that is used to estimate the status of the fan system. The internal fan characteristic includes, for example, relational expressions and tables that represent a fan characteristic itself of the fan 6.

In addition, correlated information includes, for example, control parameters used to control the fan system. The control parameters include, for example, command values used by the drive control unit 83 to achieve the specified status of the fan system, and thresholds used by the clogging determination unit 86.

Here, fan characteristics of fan 6 are described.

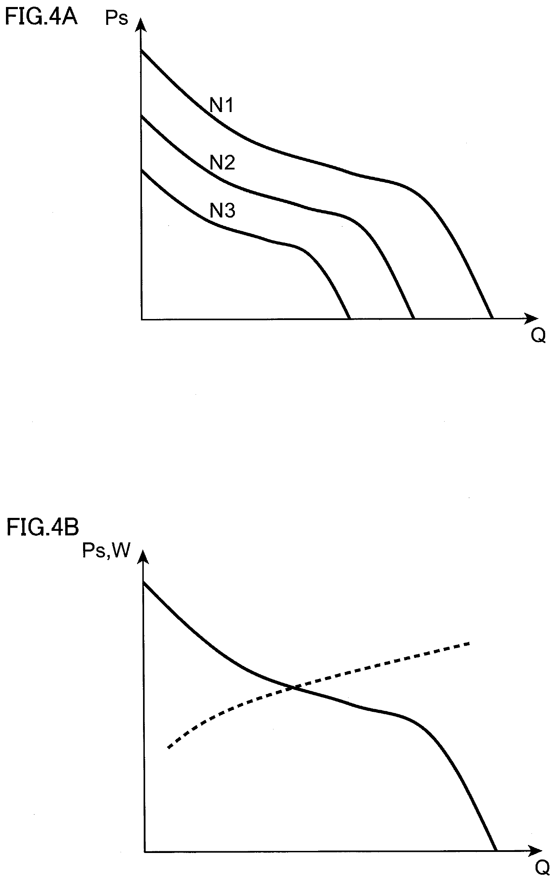

FIGS. 4A and 4B show fan characteristics according to the present embodiment, where FIG. 4A shows a differential pressure characteristic, and FIG. 4B shows a power characteristic.

In FIG. 4A, the differential pressure characteristic represents a relationship between the static pressure Ps, which indicates the differential pressure across the filter 13, and the airflow Q of the fan 6. At different rotation speeds N (N1, N2, N3) of the fan 6, there is similarity between the differential pressure characteristics corresponding to the respective rotation speeds N.

In FIG. 4B, the power characteristic takes into account not only the differential pressure characteristic shown by the solid line, but also a relationship between the driving power W for the motor 7 and the airflow Q of the fan 6 at a given rotation speed N, shown by the dashed line. The power characteristic represents the driving power W for the motor 7 at a given airflow Q and a given static pressure Ps.

The fan characteristics according to the present embodiment are not limited to those described above, but may include a relationship between the rotation speed N of the fan 6 and vibration and a relationship between the rotation speed N of the fan 6 and noise. In other words, the fan characteristics according to the present embodiment may be any information that indicates a correlation involving the fan 6 and indicates the status of the fan system of the oil cooling device 10.

We now return to FIG. 3.

Based on the information (hereinafter referred to as "correlated information") correlated to a fan characteristic, which is a characteristic of the fan 6, the drive control unit 83 adjusts the current supplied to the motor 7 to control the drive of the fan 6. The current supplied to the motor 7 is the driving force for the fan 6. For example, if the motor 7 is a three-phase motor, the current supplied to the motor 7 is a three-phase AC drive current.

Specifically, the drive control unit 83 includes, for example, an inverter circuit to convert DC from a DC source into AC to be supplied to the motor 7, and drives the motor 7 by switching multiple switching elements in this inverter circuit. The fan 6 is driven by the motor 7 to rotate.

The drive control unit 83 also adjusts the driving power and rotation speed for the fan 6 to control, for example, the airflow, vibration, and/or noise associated with the rotation of the fan 6.

The temperature estimation unit 84 acquires information correlated to the temperature of the fan 6 to estimate the temperature of the fan 6. In other words, the temperature estimation unit 84 acquires information correlated to the temperature of the fan 6 to estimate the ambient temperature of the fan 6.

In the present embodiment, the ambient temperature of the fan 6 is not limited to the temperature of the atmosphere in which the fan 6 is located, but may be the intake air temperature of the fan 6, which indicates the temperature of the air drawn in by the fan 6, or may be the temperature of the fan 6 itself.

Examples of the information correlated to the temperature of the fan 6 include measurements of the temperature of the air around the fan and direct measurements of the temperature of the fan 6 itself. Other examples of the information correlated to the temperature of the fan 6 include measurements of the temperature of the condenser 2 and measurements of the temperature of the air drawn in by the fan 6.

The temperature estimation unit 84 may use the above measurements taken by a sensor (not shown) as an estimate of the temperature of the fan 6, or may use a value calculated based on the above measurements as an estimate of the temperature of the fan 6.

The pressure loss estimation unit 85 estimates a pressure loss index z about the pressure loss across the filter 13. Specifically, the pressure loss estimation unit 85 estimates the degree of pressure loss across the filter 13 based on the degree of deceleration of the fan 6.

Even if the driving force for the fan 6 is cut off, the fan 6 continues to rotate due to inertia, but the rotation speed of the fan 6 and motor 7 decelerates due to load torque To generated on the fan 6 and motor 7. The load torque To is expressed by the following equation (1). The static pressure Ps when the filter 13 is clogged is greater than that when the filter 13 is not clogged, resulting in a greater degree of pressure loss across the filter 13.

[Equation 1]

$$To = (Ps + Pv) \times Q/N \qquad \cdots (1)$$

To: Load torque
Ps: Static pressure [Pa]
Pv: Dynamic pressure [Pa]
Q: Airflow [m$^3$/sec]
N: Rotation speed of the fan 6 or motor 7 [rps]

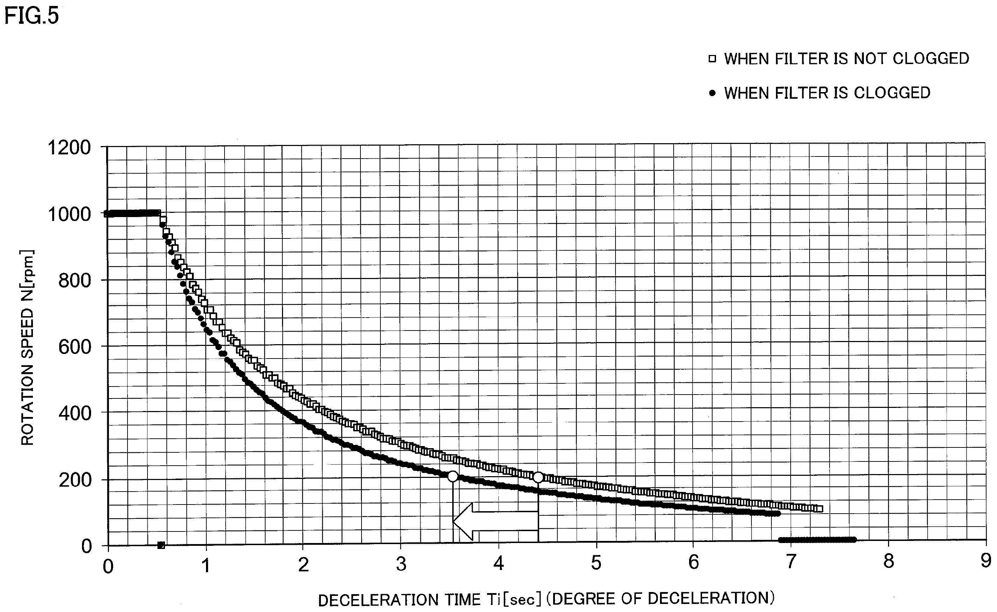

FIG. 5 shows a relationship between the pressure loss across the filter 13 and the degree of deceleration of the fan 6.

FIG. 5 shows an example where the fan 6 has a fan characteristic where the load torque To increases with an increase in the pressure loss across the filter 13. In this case, the fan 6 is an axial flow fan, such as a propeller fan.

In the example shown in FIG. 5, the vertical axis represents the rotation speed N [rpm] of the fan 6. This chart shows the results of measuring the deceleration time Ti of the fan 6 from when the driving force for the fan 6 is cut off to when the rotation speed of the fan 6 decelerates to a stop, with the rotation speed N immediately before cutting off the driving force for the fan 6 being a predetermined rotation speed. The deceleration time Ti [sec] of the fan 6 is a measurement of time from when the driving force for the fan 6 is cut off to when the fan 6 stops rotating.

As shown in FIG. 5, at the same the rotation speed N of the fan 6, the deceleration time Ti of the fan 6 when the filter 13 is clogged is shorter than the deceleration time Ti of the fan 6 when the filter 13 is not clogged. In other words, at the same the rotation speed N of the fan 6, the degree of deceleration of the fan 6 when the degree of pressure loss across the filter 13 is large is greater than the degree of deceleration of the fan 6 when the degree of pressure loss across the filter 13 is small.

As shown in FIG. 5, there is a correlation between the degree of pressure loss across the filter 13, the rotation speed N [rpm] of the fan 6, and the deceleration time Ti [sec] of the fan 6. This correlation can be used to estimate the pressure loss index z of the filter 13 based on the rotation speed N of the fan 6 and the deceleration time Ti of the fan 6.

The clogging determination unit 86 shown in FIG. 3 determines whether the filter 13 is clogged. Specifically, the clogging determination unit 86 determines that the filter 13 is clogged if the pressure loss index z of the filter 13 is at or above a preset threshold, and determines that the filter 13 is not clogged if the pressure loss index z is below the threshold.

The clogging determination unit 86 also determines that the filter 13 is clogged if, for example, the degree of deceleration of the fan 6 is at or above a threshold that is set for each rotation speed N of the fan 6, and determines that the filter 13 is not clogged if the degree of deceleration is below the threshold.

The threshold set for each rotation speed N of the fan 6 is a threshold that is set for each rotation speed N immediately before cutting off the driving force for the fan 6 when, for example, the degree of deceleration of the fan 6 is the deceleration time Ti of the fan 6. If only one rotation speed N immediately before cutting off the driving force for the fan 6 is preset for use in determination of clogging by the clogging determination unit 86, only one threshold may be set instead of setting multiple thresholds.

The communication processing unit 87 transmits information about the fan 6 to the control device 20. The communication processing unit 87 also receives information about the fan 6 from the control device 20.

The functional configuration of the control device 20 is now described.

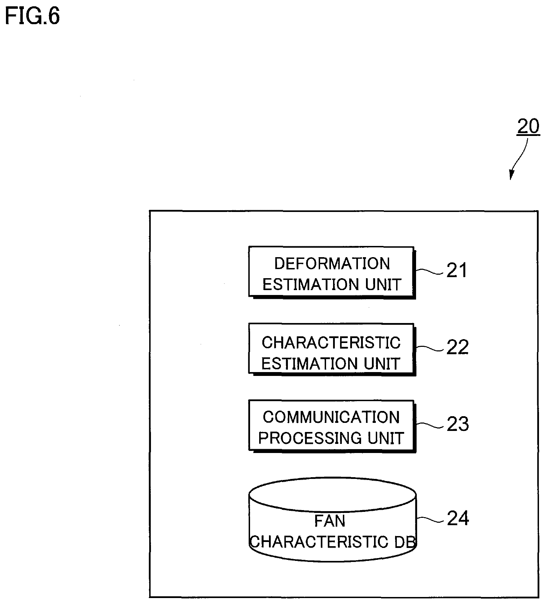

FIG. 6 shows an example functional configuration of the control device 20 according to the first embodiment.

Functions of the control device 20 shown in FIG. 2 are implemented mainly by the control unit 110.

As shown in FIG. 6, the control device 20 includes a deformation estimation unit 21, a characteristic estimation unit 22, and a communication processing unit 23. The control device 20 also includes a fan characteristic DB 24, which is an example of the fan characteristic storage unit, storing correlated information correlated to a fan characteristic(s) of the fan 6.

The deformation estimation unit 21 estimates a deformation index $x_A$, which is an index correlated to deformation of the fan 6 as a function of ageing of the fan 6 (hereinafter referred to as "deformation over time").

Specifically, the deformation estimation unit 21 estimates the degree of deformation over time of the fan 6, based on the history of acquired values from the oil cooling device 10.

The deformation estimation unit 21 may estimate, as the deformation index $x_A$ of the fan 6, the amount by which the fan 6 has been deformed (hereinafter referred to as the "deformation amount"), in addition to the index correlated to the deformation over time of the fan 6.

The rotating fan 6 is subjected to stress, which causes distortion depending on the elastic modulus of the resin material of the fan 6. If this stress continues, the elastic modulus of the resin material of the fan 6 changes and the distortion increases over time, resulting in so-called creep deformation. In the present embodiment, the creep deformation of the fan 6 over time is referred to as the deformation over time.

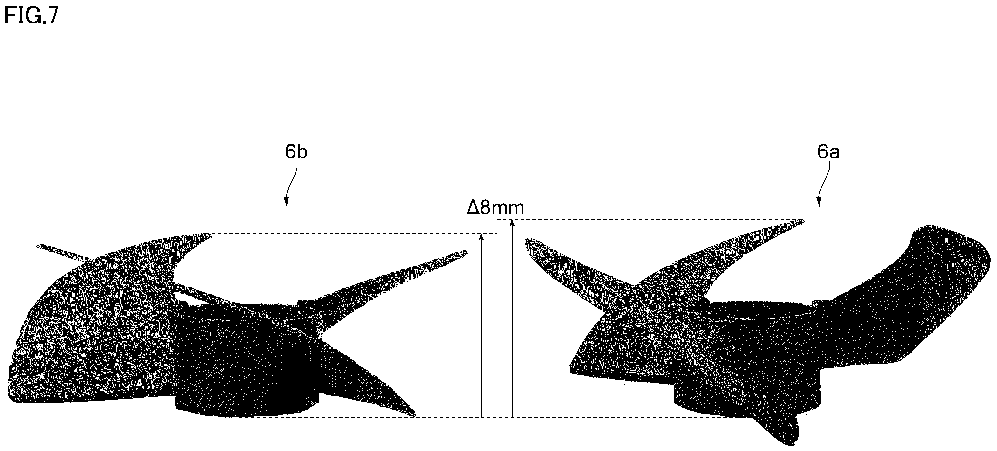

FIG. 7 shows deformation over time of the fan.

A fan 6a shown in FIG. 7 is a brand-new fan. On the other hand, a fan 6b shown in FIG. 7 is a fan of the same shape as the fan 6a and has been rotated for 170 hours at the rotation speed of 1500 [rpm] under the environment of 60°C.

Comparing the height of the fans 6 in the example shown in FIG. 7, the height of the blades is different between the fan 6a and the fan 6b. Specifically, the fan 6b has been deformed over time, resulting in a deformation amount of 8 mm. The resistance force received by the fan 6b shown in FIG. 7 when it rotates decreases compared to the fan 6a, which has not been deformed over time.

The deformation estimation unit 21 estimates the deformation index $x_A$ based on, e.g., the history of the temperature Tm of the fan 6. Specifically, the deformation estimation unit 21 calculates the deformation index $x_A$ based on, e.g., the following equation (2).

[Equation 2]

$$x_A = A * Tm * \ln(B * Tm * ti + 1) \qquad \cdots (2)$$

$x_A$: Deformation index
A, B: Constants based on the rotation speed N
Tm: Temperature of the fan 6 [°C]
ti: Operating time of the fan 6 or motor 7 [hrs]

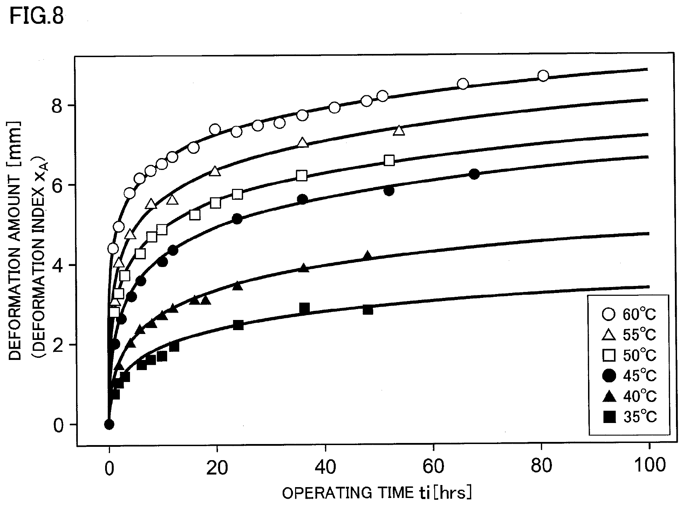

FIG. 8 shows a relationship between the history of the temperature Tm of the fan 6 and the deformation index $x_A$ of the fan 6.

FIG. 8 shows the deformation amount of the fan 6 when it is rotated at 35°C, 40°C, 45°C, 50°C, 55°C, and 60°C at the same rotation speed N.

In the example shown in FIG. 8, the horizontal axis represents the operating time ti [hrs] of the fan 6 or motor 7. The chart shows measurements of the deformation amount [mm] as the deformation index $x_A$ of the fan 6, measured at each temperature Tm [°C] of the fan 6. The regression curves, indicated by respective curves, reflect the trend of the measurements of the deformation amount indicated by dots.

The deformation index $x_A$ of the fan 6 is calculated by populating the above equation (2) with values of the constants A and B based on the rotation speed N of the fan 6, the temperature Tm of the fan 6, and the operating time ti of the fan 6 or motor 7.

Alternatively, the deformation estimation unit 21 may estimate the deformation index $x_A$ based on, e.g., the history of the rotation speed N of the fan 6 or motor 7. Specifically, the deformation estimation unit 21 may calculate the deformation index $x_A$ based on, e.g., the following equation (3).

[Equation 3]

$$x_A = a * \ln(b * ti + 1) \qquad \cdots (3)$$

$x_A$: Deformation index
a, b: Constants based on the rotation speed N of the fan 6 or motor 7 and the temperature Tm of the fan 6.
ti: Operating time of the fan 6 or motor 7 [hrs]

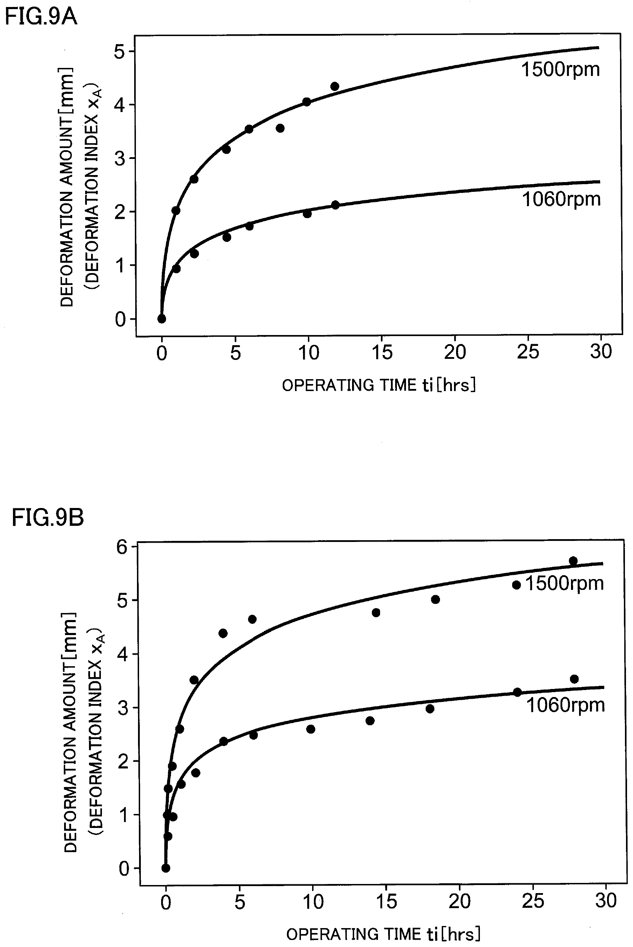

FIGS. 9A and 9B show a relationship between the history of the rotation speed N of the fan 6 or motor 7 and the deformation index $x_A$ of the fan 6, where FIG. 9A shows the case where the fan 6 is rotated at 45 [°C], and FIG. 9B shows the case where the fan 6 is rotated at 60 [°C].

FIGS. 9A and 9B show the deformation amount of the fan 6 when it is rotated at 1500 [rpm] and 1060 [rpm] at the temperature of 45 [°C] or 60 [°C].

In the example shown in FIGS. 9A and 9B, the horizontal axis represents the operating time ti of the fan 6 or motor 7. The charts show measurements of the deformation amount [mm] as the deformation index $x_A$ of the fan 6, measured at each rotation speed N of the fan 6 or motor 7. The regression curves, indicated by respective curves, reflect the trend of the measurements of the deformation amount indicated by dots.

The deformation index $x_A$ of the fan 6 is calculated by populating the above equation (3) with values of the constants a and b, which are based on the rotation speed N of the fan 6 or motor 7 and the temperature Tm of fan 6, and the operating time ti of the fan 6 or motor 7.

We now describe how to estimate the deformation index $x_A$ when the conditions under which the fan 6 is operated are changed during the course of operation.

For example, assume that the fan 6 has been operated for 5 hours at 45 [°C] and at 1500 [rpm] and is then operated for 2 hours at 60 [°C] and at 1500 [rpm].

For example, first, the above equation (3) is populated with values of the constants based on the rotation speed (1500 [rpm]) and the temperature (45 [°C]) of the fan 6 and the operating time (5 [hrs]) of the fan 6 to calculate a deformation index $x_A$' of the fan 6.

Then, the above equation (3) is populated with values of the constants based on the rotation speed (1500 [rpm]) and the temperature (60 [°C]) of the fan 6 and the calculated deformation index $x_A$' to calculate the operating time ti' to reach the deformation index $x_A$' under the conditions of 60 [°C] and 1500 [rpm].

Finally, the above equation (3) is populated with values of the constants based on the rotation speed (1500 [rpm]) and the temperature (60 [°C]) of the fan 6 and the calculated operating time ti' plus 2 hours [hrs] to calculate the deformation index $x_A$ of the fan 6.

It should be noted that the method of estimating the deformation index $x_A$ when the conditions under which the fan 6 is operated are changed during the course of operation is not limited to the above, and any estimation method that takes into account the operation history of the fan 6 may be used.

In the above example, the deformation estimation unit 21 calculates and estimates the deformation index $x_A$, but this is not limiting. The deformation estimation unit 21 may estimate the deformation index $x_A$ using, for example, a correlation diagram or table representing a correlation between the temperature Tm of the fan 6, the rotation speed N of the fan 6 or motor 7, the operating time ti of the fan 6 or motor 7, and the deformation index $x_A$.

We now return to FIG. 6.

The characteristic estimation unit 22 estimates information about a fan characteristic of the fan 6.

Specifically, the characteristic estimation unit 22 estimates correlated information that is correlated to a fan characteristic as a function of deformation over time of the fan 6, based on the history of acquired values from the oil cooling device 10.

The fan characteristic has a variable correlation as a function of deformation over time of the fan 6. Specifically, correlated information that is correlated to the fan characteristic of a fan 6 that has been deformed over time is different from correlated information that is correlated to a fan characteristic y of an initial fan 6 that has not been deformed over time (hereinafter referred to as the "initial characteristic y").

The characteristic estimation unit 22 estimates the correlated information based on at least one of the temperature Tm of the fan 6 and the rotation speed N of the fan 6. In other words, the characteristic estimation unit 22 corrects the correlated information based on at least one of the temperature Tm of the fan 6 and the rotation speed N of the fan 6.

The characteristic estimation unit 22 is an example of the correction unit.

The characteristic estimation unit 22 estimates, based on, e.g., the history of acquired values from the oil cooling device 10, a fan characteristic Y that is corrected to correspond to the fan 6 that has been deformed over time (hereinafter referred to as the "corrected characteristic Y"), as an internal fan characteristic as a function of deformation over time of the fan 6. Specifically, the characteristic estimation unit 22 calculates the corrected characteristic Y based on, e.g., the following equation (4).

[Equation 4]

$$
\begin{aligned}
Y &= x_A * y \\
&= A * Tm * \ln(B * Tm * ti + 1) * y \qquad \cdots (4) \\
&= a * \ln(b * ti + 1) * y
\end{aligned}
$$

Y: Corrected characteristic
y: Initial characteristic
$x_A$: Deformation index
Tm: Temperature of the fan 6
A, B: Constants based on the rotation speed N
a, b: Constants based on the rotation speed N of the fan 6 or motor 7 and the temperature Tm of the fan 6
ti: Operating time of the fan 6 or motor 7 [hrs]

The characteristic estimation unit 22 is not limited to being configured to correct the relational expression itself representing the fan characteristic of the fan 6. The characteristic estimation unit 22 may estimate the correlated information by adding, to the calculation result based on the initial characteristic y, a correction value to correspond to the fan 6 that has been deformed over time.

The characteristic estimation unit 22 may also estimate, based on e.g., the history of acquired values from the oil cooling device 10, a command value or threshold that is corrected to correspond to the fan 6 that has been deformed over time, as control parameters as a function of deformation over time of the fan 6.

The calculation of the corrected characteristic Y using the history of acquired values may be performed in response to a predetermined condition being satisfied. Examples of the predetermined condition upon satisfaction of which the calculation of the corrected characteristic Y using the history of acquired values is performed include when the clogging determination unit 86 determines a clogging of the filter 13, when the oil cooling device 10 is turned on, and when the oil cooling device 10 is turned off. Further examples of the predetermined condition upon satisfaction of which the calculation of the corrected characteristic Y using the history of acquired values is performed include when a predetermined period of time has elapsed and when a value of at least one of the temperature Tm of the fan 6 and the rotation speed N of the fan 6 has changed.

Still alternatively, the characteristic estimation unit 22 may obtain the history of acquired values from the oil cooling device 10 to learn the fan characteristic corresponding to the fan 6 that has been deformed over time.

In this case, the control device 20 ensures that the oil cooling device 10 is controlled based at least on the history of a physical quantity that is correlated to the temperature Tm of the fan 6.

The functions of the characteristic estimation unit 22 are not limited to those described above, and the correlated information may be processed in any way that ensures that the oil cooling device 10 is controlled based on the correlation that varies as a function of deformation over time of the fan 6.

**EP 4 596 887 A1**

The communication processing unit 23 receives information about the fan 6 from the oil cooling device 10. Specifically, the communication processing unit 23 receives, from the oil cooling device 10, acquired values that represent a physical quantity(ies) indicative of the status of the oil cooling device 10 constituting the fan system.

The communication processing unit 23 also transmits information about the fan 6 to the oil cooling device 10. Specifically, the communication processing unit 23 transmits correlated information about the fan 6 to the oil cooling device 10.

(Airflow control)

A process for controlling the airflow of the fan 6 is now described.

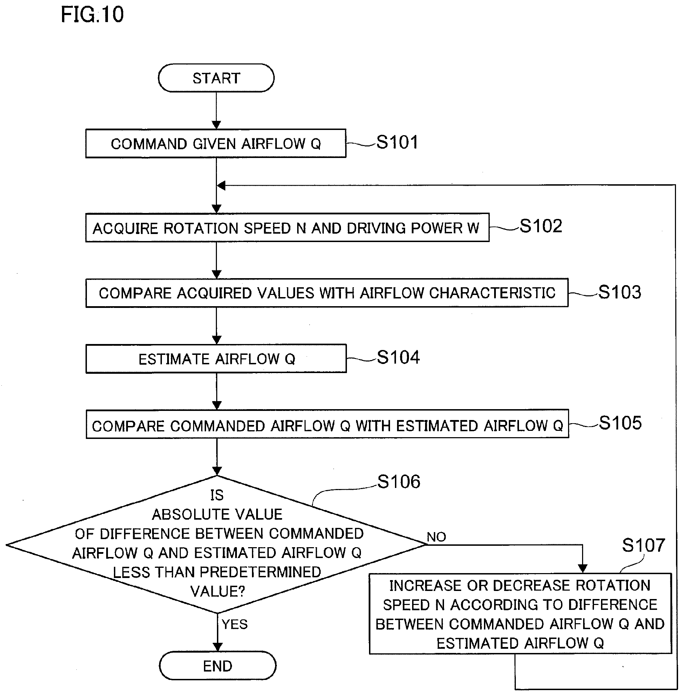

FIG. 10 is a flowchart showing a process flow for controlling the airflow of the fan 6.

FIG. 10 shows an example where the airflow is controlled at a constant rate based on an airflow characteristic that represents a correlation between the rotation speed N of the fan 6 and the driving power W for the motor 7 for achieving a given airflow Q.

The airflow characteristic is an example of the fan characteristic and represents a relationship between at least one of the driving power W for the motor 7, the rotation speed N of the fan 6, and the static pressure Ps of the fan 6 and the airflow of the fan 6.

The oil cooling device 10 commands a given airflow Q (S101). Specifically, the oil cooling device 10 commands the airflow Q of the fan 6 to be, e.g., an airflow $Q_B$.

Then, the oil cooling device 10 acquires the rotation speed N1 of the fan 6 and the driving power W1 for the motor 7 as acquired values (S102). Specifically, the oil cooling device 10 acquires the rotation speed N1 of the fan 6 and the driving power W1 for the motor 7 as physical quantities correlated to the airflow Q.

The oil cooling device 10 compares the acquired values with the airflow characteristic of the fan 6 (S103).

Here, the airflow characteristic of the fan 6 is described.

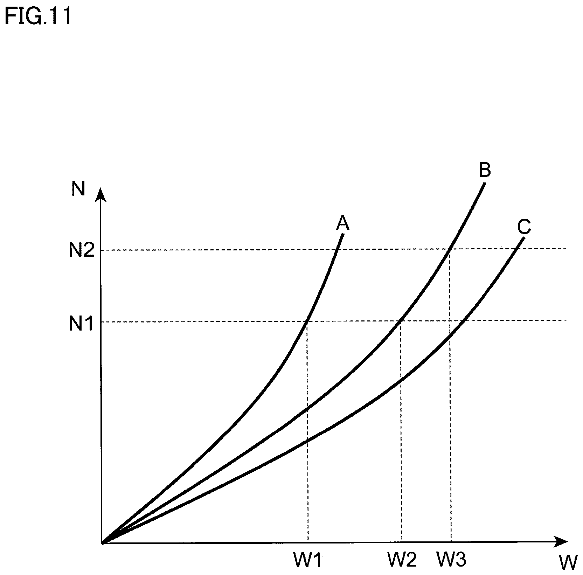

FIG. 11 shows a relationship between the rotation speed N of the fan 6 and the driving power W for the motor.

FIG. 11 shows a correlation between the rotation speed N of the fan 6 and the driving power W for the motor 7 for an airflow characteristic that achieves a given airflow Q even with the occurrence of pressure loss across the filter 13.

In the example shown in FIG. 11, a correlation between the rotation speed N of the fan 6 and the driving power W for the motor 7 is indicated by solid lines, each for an airflow characteristic A that achieves an airflow $Q_A$, an airflow characteristic B that achieves an airflow $Q_B$ greater than the airflow $Q_A$, and an airflow characteristic C that achieves an airflow $Q_C$ greater than the airflow $Q_B$.

The correlation shown in FIG. 11 indicates an initial characteristic y for the airflow of an initial fan 6 that has not been deformed over time.

For example, if the fan 6 is rotated under the conditions of the rotation speed N1 and the driving power W2 with no clogging of the filter 13, the airflow $Q_B$ is delivered.

On the other hand, if, for example, the fan 6 is rotated under the conditions of the rotation speed N1 with the filter 13 clogged, the airflow Q will be smaller than the airflow $Q_B$ due to reduced volume of air passing through the filter 13. In the example shown in FIG. 11, if the fan 6 is rotated under the conditions of the rotation speed N1 and the driving power W1, the airflow $Q_A$ smaller than the airflow $Q_B$ is delivered.

To achieve the airflow $Q_B$ with the filter 13 clogged, for example, the rotation speed N of the fan 6 may be increased to the rotation speed N2, and the driving power W for the motor 7 may be adjusted to driving power W3 based on the airflow characteristic B shown in FIG. 11.

Then, the oil cooling device 10 estimates the airflow Q based on the acquired values and the airflow characteristic of the fan 6 (S104). Specifically, the oil cooling device 10 estimates that the airflow Q of the fan 6 is, for example, the airflow $Q_A$, based on the airflow characteristic A passing through the intersection of the rotation speed N1 and the driving power W1.

The oil cooling device 10 then compares the commanded airflow Q with the estimated airflow Q (S105).

The oil cooling device 10 determines whether the absolute value of the difference between the commanded airflow Q and the estimated airflow Q is less than a predetermined value (S106).

If the absolute value of the difference between the commanded airflow Q and the estimated airflow Q is greater than or equal to the predetermined value (No in S106), the oil cooling device 10 increases or decreases the rotation speed N according to the difference between the commanded airflow Q and the estimated airflow Q (S107). Specifically, the oil cooling device 10 increases or decreases the rotation speed N according to the magnitude of the absolute value of the difference between the commanded airflow Q and the estimated airflow Q and which of the commanded airflow Q and the estimated airflow Q is greater.

For example, where the commanded airflow Q is greater than the estimated airflow Q, the rotation speed N is increased by 2 [rpm] if the absolute value of the difference between the commanded airflow Q and the estimated airflow Q is greater than or equal to a threshold, and the rotation speed N is increased by 1 [rpm] if the absolute value of the difference between the commanded airflow Q and the estimated airflow Q is less than the threshold. Where the commanded airflow Q is smaller than the estimated airflow Q, the rotation speed N is reduced according to the magnitude of the absolute value of the difference between the commanded airflow Q and the estimated airflow Q.

The oil cooling device 10 then repeats the process from S102 onward until the absolute value of the difference between the commanded airflow Q and the estimated airflow Q becomes less than the predetermined value.

In S106, if the absolute value of the difference between the commanded airflow Q and the estimated airflow Q is less than the predetermined value (Yes in S106), the oil cooling device 10 terminates the process.

If the fan 6 has been deformed over time, the airflow characteristic will change from the initial characteristic y. Thus, a situation may arise where the airflow Q cannot be controlled at a constant rate even if the driving power W for the motor 7 is adjusted based on the airflow characteristic shown in FIG. 11.

In the present embodiment, the control device 20 corrects a relational expression representing a correlation between the airflow Q, the rotation speed N, and the driving power W, based on at least one of the temperature Tm of the fan 6 and the rotation speed N of the fan 6, which are the acquired values. Alternatively, the control device 20 identifies a correction value for correcting the results, calculated from the relational expression representing the correlation between the airflow Q, the rotation speed N, and the driving power W, to make the results correspond to the fan 6 deformed over time. The control device 20 then provides the corrected relational expression or the identified correction value to the oil cooling device 10.

This helps the oil cooling device 10 to control the airflow of the fan 6 at a constant rate, regardless of whether or not the fan 6 has been deformed over time.

Alternatively, a command value for a given airflow Q may be corrected to correspond to the fan 6 that has been deformed over time. In this case, the control device 20 provides to the oil cooling device 10 the corrected command value for the given airflow Q or a correction value for correcting the command value for the given airflow Q to make it correspond to the fan 6 that has been deformed over time.

Still alternatively, where the effect of changes in an airflow path characteristic, which is a measure of the difficulty in air flowing through the flow path within the oil cooling device 10, due to clogging of the filter or other reasons is small, the oil cooling device 10 may identify a driving power W to achieve a given commanded airflow Q, based on a relational expression representing a correlation between the airflow Q and the driving power W.

In this case, the oil cooling device 10 adjusts the rotation speed N of the fan 6 so that the given commanded airflow Q is achieved based on a commanded driving power W. Specifically, the oil cooling device 10 adjusts the command value for the rotation speed N of the fan 6 based on a driving power W commanded as the driving power W that can achieve the given commanded airflow Q.

The control device 20 corrects the relational expression representing the correlation between the airflow Q and the driving power W, based on at least one of the temperature Tm of the fan 6 and the rotation speed N of the fan 6, which are the acquired values. Alternatively, the control device 20 identifies a correction value for correcting the results, calculated from the relational expression representing the correlation between the airflow Q and the driving power W, to make the results correspond to the fan 6 deformed over time. The control device 20 then provides the corrected relational expression or the identified correction value to the oil cooling device 10.

Alternatively, a command value for a given airflow Q or a command value for the rotation speed N may be corrected to correspond to the fan 6 that has been deformed over time. In this case, the control device 20 provides to the oil cooling device 10 the corrected command value for the given airflow Q or for the rotation speed N or a correction value for correcting the command value for the given airflow Q or for the rotation speed N to make it correspond to the fan 6 that has been deformed over time.

Still alternatively, where the effect of changes in the airflow path characteristic, which is a measure of the difficulty in air flowing through the flow path within the oil cooling device 10, due to clogging of the filter or other reasons is small, the oil cooling device 10 may identify a rotation speed N to achieve a given commanded airflow Q, based on a relational expression representing a correlation between the airflow Q and the rotation speed N. In this case, the oil cooling device 10 adjusts the rotation speed N of the fan 6 so that the given commanded airflow Q is achieved using the commanded rotation speed N. Specifically, the oil cooling device 10 adjusts the command value for the rotation speed N of the fan 6 to be a value with which the given commanded airflow Q can be achieved.

The control device 20 also corrects the relational expression representing the correlation between the airflow Q and the rotation speed N, based on at least one of the temperature Tm of the fan 6 and the rotation speed N of the fan 6, which are the acquired values. Alternatively, the control device 20 identifies a correction value for correcting the results, calculated from the relational expression representing the correlation between the airflow Q and the rotation speed N, to make the results correspond to the fan 6 deformed over time. The control device 20 then provides the corrected relational expression or the identified correction value to the oil cooling device 10.

It should be noted that, regarding a command value for adjusting the rotation speed N of the fan 6 so that a given airflow Q commanded by the oil cooling device 10 matches the airflow Q measured by a sensor or other means, the control device 20 does not provide a corrected command value nor a correction value.

Second Embodiment

In the above example, the correlated information about the fan 6 estimated by the control device 20 of the present disclosure is used to control the airflow Q of the fan 6. However, this implementation is not limiting. The correlated information about the fan 6 estimated by the control device 20 of the present disclosure may be used to monitor the static pressure Ps of the fan 6.

The correlated information used to monitor the static pressure Ps of the fan 6 is an example of the fan characteristic and represents a relationship between a physical quantity(ies) correlated to the static pressure Ps of the fan 6 and the static pressure Ps of the fan 6.

Now, a process for determining a clogging of the filter 13 based on monitoring the static pressure Ps of the fan 6 is described.

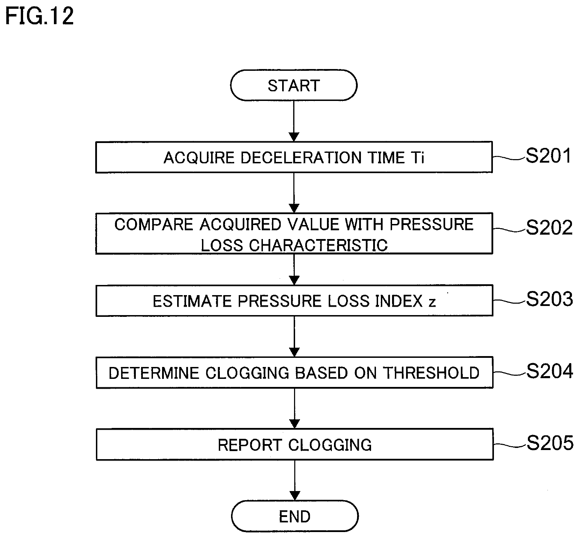

FIG. 12 is a flowchart showing a process flow for determining a clogging of the filter 13.

FIG. 12 shows an example where a clogging of the filter 13 is determined based on a pressure loss characteristic representing a correlation between the deceleration time Ti of the fan 6 at a rotation speed N and the pressure loss index z across the filter 13.

The oil cooling device 10 acquires the deceleration time Ti of the fan 6 as the acquired value (S201). Specifically, the oil cooling device 10 acquires the deceleration time Ti of the fan 6 as a physical quantity correlated to the pressure loss index z.

The oil cooling device 10 compares the acquired value with the pressure loss characteristic of the fan 6 (S202).

Here, the pressure loss characteristic of the fan 6 is described.

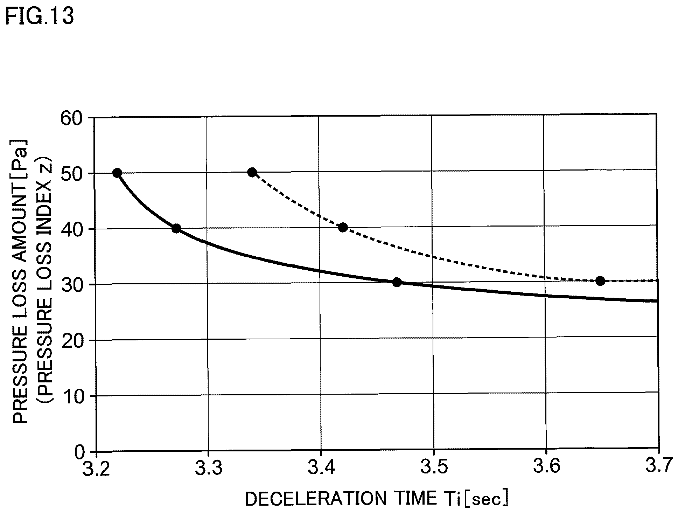

FIG. 13 shows a relationship between the deceleration time Ti of the fan 6 and the pressure loss index z across the filter 13 when the rotation speed N immediately before cutting off the driving power W for the fan 6 is a predetermined rotation speed.

FIG. 13 shows the deceleration time Ti [sec] of the fan 6a (see FIG. 7) and the deceleration time Ti [sec] of the fan 6b (see FIG. 7) for each pressure loss value [Pa] across the filter 13.

In the example shown in FIG. 13, the horizontal axis represents the deceleration time Ti of each fan 6. The chart shows measurements of the pressure loss value [Pa] as the pressure loss index z of the filter 13, measured for both the fan 6 that has been deformed over time and the fan 6 that has not been deformed over time.

In the example shown in FIG. 13, at the pressure loss value across the filter 13 of 40 [Pa], the deceleration time Ti of the fan 6 that has not been deformed over time is 3.27 [sec], while the deceleration time Ti of the fan 6 that has been deformed over time is 3.42 [sec].

The fan 6 that has been deformed over time receives a lower resistance force than the fan 6 that has not been deformed over time, resulting in a longer deceleration time Ti of the fan 6.

The regression curves, indicated by respective curves, reflect the trend of the measurements of the pressure loss value indicated by dots.

In FIG. 13, a correlation between the deceleration time Ti of the fan 6a (see FIG. 7) and the pressure loss index z across filter 13 is indicated by the solid line, and a correlation between the deceleration time Ti of the fan 6b (see FIG. 7) and the pressure loss index z across the filter 13 is indicated by the dashed line.

In other words, FIG. 13 shows the initial pressure loss characteristic y of the initial fan 6 that has not been deformed over time as the solid line, and the pressure loss characteristic of the fan 6 that has been deformed over time as the dashed line.

Then, the oil cooling device 10 estimates the pressure loss index z based on the acquired value and the pressure loss characteristic of the fan 6 (S203). Specifically, the oil cooling device 10 estimates the pressure loss index z based on the deceleration time Ti and the pressure loss characteristic of the fan 6.

The oil cooling device 10 determines a clogging of the filter 13 based on a threshold (S204). Specifically, the oil cooling device 10 determines that the filter 13 is clogged if the pressure loss index z is at or above the threshold, and determines that the filter 13 is not clogged if the pressure loss index z is below the threshold.

This process example assumes that the filter 13 has been determined to be clogged.

The oil cooling device 10 reports the clogging of the filter 13 (S205) and terminates the process. Specifically, the oil cooling device 10 reports the clogging of the filter 13 via, for example, sound, light, image or text display, e-mail or other communication means, or any combination thereof, and terminates the process.

If the fan 6 has been deformed over time, the pressure loss characteristic will change from the initial characteristic y. Thus, a situation may arise where the determination of a clogging of the filter 13 based on the initial characteristic y shown in FIG. 13 provides less accuracy.

In the present embodiment, the control device 20 corrects a relational expression representing the correlation between the deceleration time Ti and the pressure loss index z, based on at least one of the temperature Tm of the fan 6 and the rotation speed N of the fan 6, which are the acquired values. Alternatively, the control device 20 identifies a correction value for correcting the results, calculated from the relational expression representing the correlation between the deceleration time Ti and the pressure loss index z, to make the results correspond to the fan 6 deformed over time. The control device 20 then provides the corrected relational expression or the identified correction value to the oil cooling device 10.

The oil cooling device 10 estimates the pressure loss index z based on, e.g., the history of acquired values from the oil cooling device 10 and the relational expression that has been corrected to correspond to the fan 6 deformed over time. Specifically, the oil cooling device 10 calculates the pressure loss index z based on, e.g., the following equation (5).

This helps the oil cooling device 10 to maintain the accuracy in determining a clogging of the filter 13, regardless of whether or not the fan 6 has been deformed over time.

[Equation 5]

$$
\begin{aligned}
z &= Ti * Y \\
&= Ti * x_A * y \\
&= Ti * A * Tm * \ln(B * Tm * ti + 1) * y \\
&= Ti * a * \ln(b * ti + 1) * y
\end{aligned}
\qquad \cdots (5)
$$

z: Pressure loss index
Ti: Deceleration time
Y: Corrected characteristic
y: Initial characteristic
$x_A$: Deformation index
Tm: Temperature of the fan 6
A, B: Constants based on the rotation speed N
a, b: Constants based on the rotation speed N of the fan 6 or motor 7 and the temperature Tm of the fan 6
ti: Operating time of the fan 6 or motor 7 [hrs]

Alternatively, the oil cooling device 10 may determine that the filter 13 is clogged if the deceleration time Ti is below a threshold, and determine that the filter 13 is not clogged if the deceleration time Ti is at or above the threshold.

In this case, the control device 20 corrects the threshold set for the deceleration time Ti to make it correspond to the fan 6 that has been deformed over time. The control device 20 then provides the corrected threshold for the deceleration time Ti to the oil cooling device 10.

Physical quantities correlated to the pressure loss index z are not limited to the deceleration time Ti of the fan 6, but also include, for example, the driving power W for the motor 7, the rotation speed N of the fan 6, and the degree of disturbance. The term "disturbance" refers to irregular fluctuations in the direction of the fluid flow, the velocity of the fluid flow, or the pressure of the fluid.

When the rotation speed N of the fan 6 is controlled to be constant, the average rotation speed N of the fan 6 will be constant, though the rotation speed N will fluctuate slightly. On the other hand, an increased clogging of the filter 13 leads to an increased pressure loss value across the filter 13. Such an increase in pressure loss value across the filter 13 leads to an increased degree of disturbance of the air conveyed by the fan.

Third Embodiment

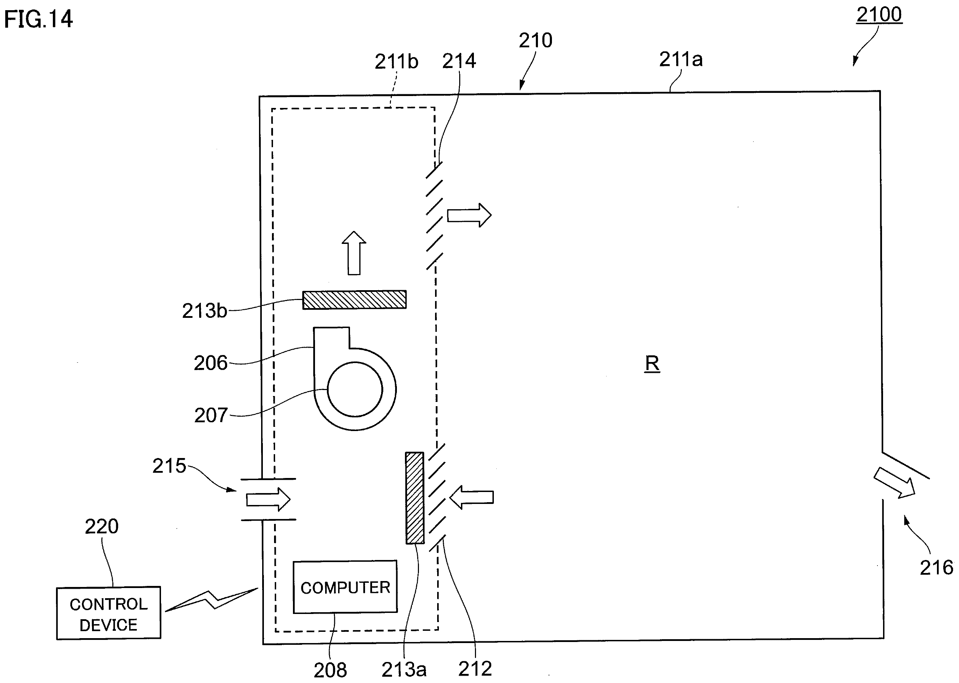

FIG. 14 shows a schematic configuration of a control system 2100 according to a third embodiment.

A distinction of the control system 2100 according to the third embodiment from the control system 100 according to the first embodiment relates to a clean room 210, which corresponds to the oil cooling device 10. The distinction from the first embodiment is described below.

The control system 2100 includes a clean room 210 and a control device 220 to control the clean room 210. In the control system 2100, the clean room 210 and the control device 220 can communicate with each other via communication lines.

The clean room 210 as an example of the fan system includes a fan 206 and a motor 207 for driving the fan 206, and controls the static pressure Ps of the clean room 210. The clean room 210 is an apparatus to control the static pressure Ps such that, for example, the air pressure inside a room R of the clean room 210 surrounded by an enclosure 211a is higher than the atmospheric pressure.

The clean room 210 includes the fan 206, the motor 207, and a computer 208. The fan 206, the motor 207, and the computer 208 are housed in an enclosure 211b. The enclosure 211b is provided with an air inlet 212 to draw air from the room R and an air outlet 214 to discharge air from the room R. Also attached to the enclosure 211b are a filter 213a to filter the air drawn from the room R and a filter 213b to purify the air to be discharged into the room R.

The enclosure 211b is housed in the enclosure 211a. The enclosure 211a is provided with a duct 215 to draw air from outside the clean room 210 and an air damper 216 to discharge air from the room R to outside the clean room 210.

The control device 220 as an example of the control device ensures that the clean room 210 is controlled based on correlated information correlated to a fan characteristic of the fan 206.

Specifically, the control device 220 acquires information about the clean room 210 from the clean room 210. The control device 220 provides correlated information to the clean room 210 according to the information about the clean room 210.

(Static pressure control)

A process for controlling the static pressure Ps in the room R of the clean room 210 is now described.

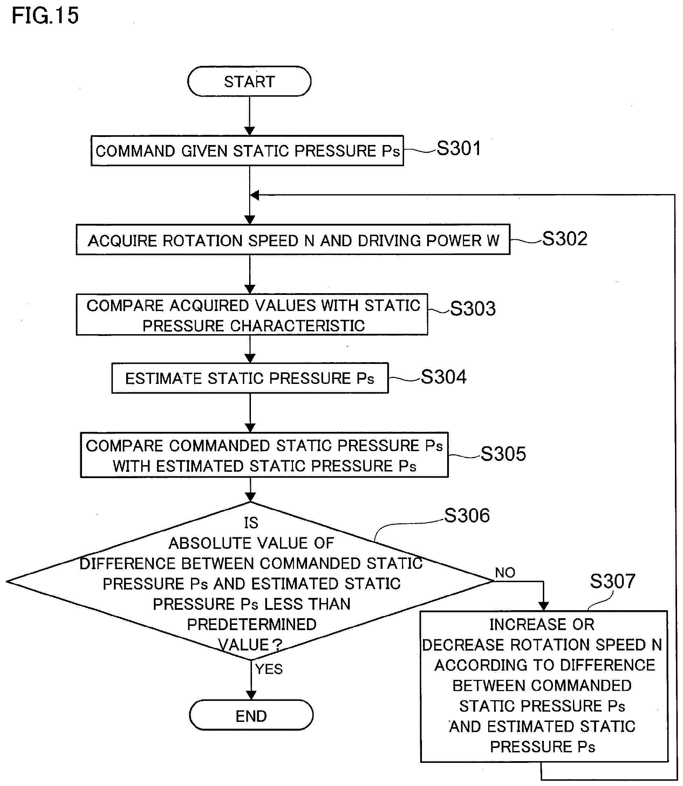

FIG. 15 is a flowchart showing a process flow for controlling the static pressure Ps of the fan 206.

FIG. 15 shows an example where the airflow is controlled at a constant rate based on a static pressure characteristic that represents a correlation between the rotation speed N of the fan 206 and the driving power W for the motor 207 to achieve a given static pressure Ps.

The clean room 210 commands a given static pressure Ps (S301).

Next, the clean room 210 acquires the rotation speed N1 of the fan 206 and the driving power W1 for the motor 207 as acquired values (S302).

It should be noted that physical quantities correlated to the static pressure Ps are not limited to the rotation speed N1 of the fan 6 and the driving power W1 for the motor 7, but also include, for example, the deceleration time Ti of the fan 6 and the degree of disturbance.

The clean room 210 then compares the acquired values with the static pressure characteristic of the fan 206 (S303).

The clean room 210 estimates the static pressure Ps based on the acquired values and the static pressure characteristic of the fan 206 (S304). Specifically, the clean room 210 estimates the static pressure Ps across the fan 206 based on the static pressure characteristic passing through the intersection of the rotation speed N1 and the driving power W1.

The clean room 210 then compares the commanded static pressure Ps with the estimated static pressure Ps (S305).

The clean room 210 determines whether the absolute value of the difference between the commanded static pressure Ps and the estimated static pressure Ps is less than a predetermined value (S306).

If the absolute value of the difference between the commanded static pressure Ps and the estimated static pressure Ps is greater than or equal to the predetermined value (No in S306), the clean room 210 increases or decreases the rotation speed N according to the difference between the commanded static pressure Ps and the estimated static pressure Ps (S307). Specifically, the clean room 210 increases or decreases the rotation speed N according to the magnitude of the absolute value of the difference between the commanded static pressure Ps and the estimated static pressure Ps and which of the commanded static pressure Ps and the estimated static pressure Ps is greater.

For example, where the commanded static pressure Ps is greater than the estimated static pressure Ps, the rotation speed N is increased by 2 [rpm] if the absolute value of the difference between the commanded static pressure Ps and the estimated static pressure Ps is greater than or equal to a threshold, and the rotation speed N is increased by 1 [rpm] if the absolute value of the difference between the commanded static pressure Ps and the estimated static pressure Ps is less than the threshold. Where the commanded static pressure Ps is less than the estimated static pressure Ps, the rotation speed N is reduced according to the magnitude of the absolute value of the difference between the commanded static pressure Ps and the estimated static pressure Ps.

The clean room 210 then repeats the process from S302 onward until the absolute value of the difference between the commanded static pressure Ps and the estimated static pressure Ps becomes less than the predetermined value.

In S306, if the absolute value of the difference between the commanded static pressure Ps and the estimated static pressure Ps is less than the predetermined value (Yes in S306), the clean room 210 terminates the process.

In this process example, the control device 220 corrects a relational expression representing a correlation between the static pressure Ps, the rotation speed N, and the driving power W, based on at least one of the temperature Tm of the fan 206 and the rotation speed N of the fan 206, which are the acquired values. Alternatively, the control device 220 identifies a correction value for correcting the results, calculated from the relational expression representing the correlation between the static pressure Ps, the rotation speed N, and the driving power W, to make the results correspond to the fan 206 deformed over time. The control device 220 then provides the corrected relational expression or the identified correction value to the clean room 210.

This helps monitor the static pressure Ps in the room R of the clean room 210 and prevent air from flowing into the room R through the air damper 216 or the like, regardless of whether or not the fan 206 has been deformed over time.

Fourth Embodiment

The correlated information about the fan 6 estimated by the control device 20 or the like of the present disclosure may be used to, for example, monitor the fan system for any abnormalities.

The correlated information used for the monitoring of fan system abnormalities is an example of the fan characteristic and represents a relationship between a physical quantity(ies) that is correlated to the monitoring of fan system abnormalities and the monitoring of fan system abnormalities.

The correlated information about the fan 6 is used to, for example, monitor the vibration and/or noise associated with the rotation of the fan 6 and to monitor the components of the fan system for any abnormalities.

(Vibration suppression)

Now, a process for suppressing vibration caused by the fan 6, which is an example of the fan system abnormalities, is described.

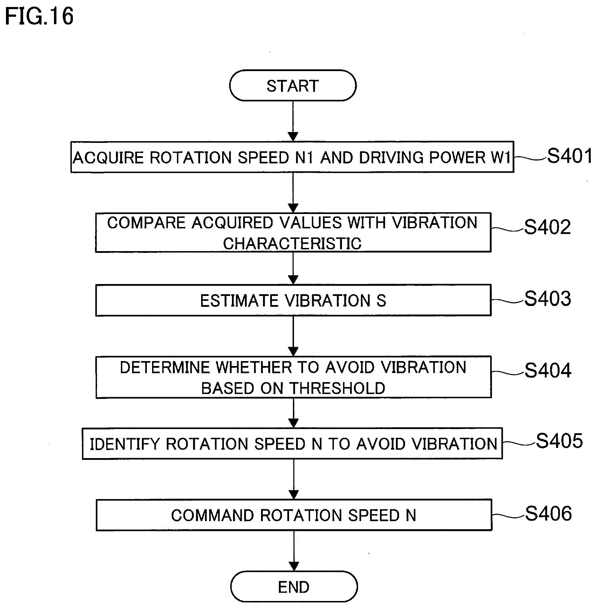

FIG. 16 is a flowchart showing a process flow for suppressing vibration caused by the fan 6.

FIG. 16 shows an example where the vibration caused by the fan 6 is controlled based on a vibration characteristic that represents a correlation between the differential pressure characteristic across the filter 13 and the airflow path characteristic, which is a measure of the difficulty in air passing through the flow path within the oil cooling device 10.

The oil cooling device 10 acquires the rotation speed N1 of the fan 6 and the driving power W1 for the motor 7 as acquired values (S401). Physical quantities correlated to the vibration caused by the fan 6 are not limited to the rotation speed N1 of the fan 6 and the driving power W1 for the motor 7, but also include, for example, the deceleration time Ti of the fan 6 and the degree of disturbance.

The oil cooling device 10 compares the acquired values with the vibration characteristic of the fan 6 (S402).

Here, the vibration characteristic of the fan 6 is described.

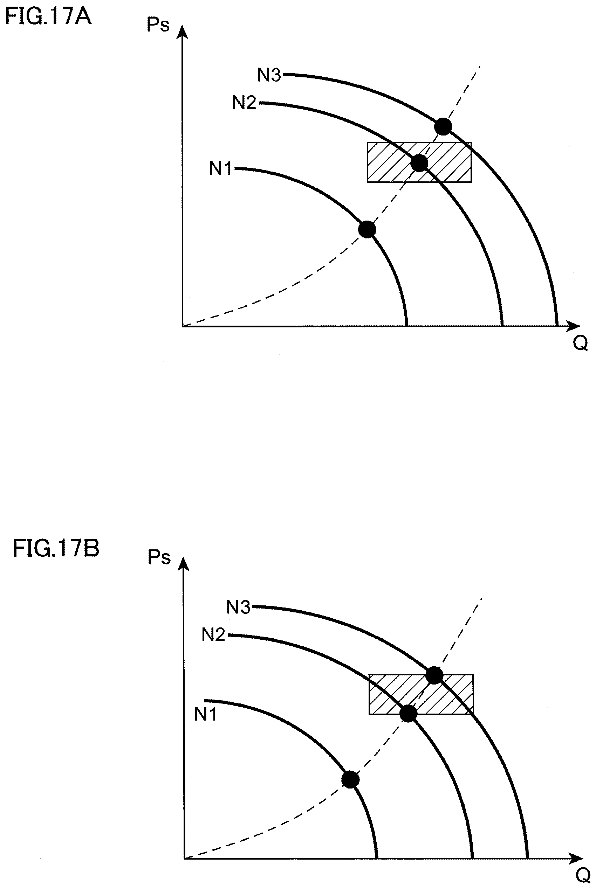

FIGS. 17A and 17B show a relationship between the vibration characteristic of the fan 6 and the vibration area, where FIG. 17A shows the case of an initial fan 6 that has not been deformed over time, and FIG. 17B shows the case of a fan 6 that has been deformed over time.

In each of FIGS. 17A and 17B, the differential pressure characteristic at different rotation speeds N (N1, N2, N3) of the fan 6 is indicated by solid lines, and the airflow path characteristic by a dashed line. The vibration area is indicated by the rectangle. Each intersection of the differential pressure characteristic and the airflow path characteristic indicates the airflow Q and the static pressure Ps when the fan 6 rotates at the corresponding rotation speed N.

In FIG. 17A, the intersection of the airflow Q and the static pressure Ps when the fan 6 rotates at the rotation speed N2 is within the vibration area. In this case, vibration associated with the rotation of the fan 6 occurs.

The oil cooling device 10 avoids the rotation speed N2 and rotates the fan 6 at the rotation speed N1 or N3 to suppress the vibration associated with the rotation of the fan 6.

Deformation over time of the fan 6 changes the differential pressure characteristic, which in turn changes the vibration characteristic of the fan 6.

In the example shown in FIG. 17B, the intersection of the airflow Q and the static pressure Ps when the fan 6 rotates at the rotation speed N2 as well as the intersection of the airflow Q and the static pressure Ps when the fan 6 rotates at the rotation speed N3 are within the vibration area.

In this case, the oil cooling device 10 avoids the rotation speeds N2, N3 and rotates the fan 6 at the rotation speed N1 to suppress the vibration associated with the rotation of the fan 6.

Next, the oil cooling device 10 estimates the vibration S associated with the rotation of the fan 6 based on the acquired values and the vibration characteristic of the fan 6 (S403).

The oil cooling device 10 determines whether or not to avoid the vibration associated with the rotation of the fan 6 based on a threshold (S404). Specifically, the oil cooling device 10 determines that vibration is to be avoided if the estimated vibration S is at or above the threshold, and determines that there is no need to avoid vibration if the estimated vibration S is below the threshold.

This process example assumes that the oil cooling device 10 has determined that vibration is to be avoided.

The oil cooling device 10 identifies the rotation speed N to avoid vibration associated with the rotation of the fan 6, based on a relational expression representing the vibration characteristic (S405).

The oil cooling device 10 commands the identified rotation speed N (S406) and terminates the process.

If the fan 6 has been deformed over time, the vibration characteristic will change from the initial characteristic y. Thus, a situation may arise where the vibration associated with the rotation of the fan 6 cannot be suppressed even if the rotation speed N2 is avoided.

In the present embodiment, the control device 20 corrects the relational expression representing the vibration characteristic, based on at least one of the temperature Tm of the fan 6 and the rotation speed N of the fan 6, which are the acquired values. Alternatively, the control device 20 identifies a correction value for correcting the results, calculated from the relational expression representing the vibration characteristic, to make the results correspond to the fan 6 deformed over time. The control device 20 then provides the corrected relational expression or the identified correction value to the oil cooling device 10.

This helps the oil cooling device 10 to suppress the vibration associated with the rotation of the fan 6, regardless of whether or not the fan 6 has been deformed over time.

Alternatively, the threshold or the vibration area may be corrected to correspond to the fan 6 that has been deformed over time.

(Reporting process)

When the estimated vibration is at or above the threshold, the oil cooling device 10 performs a reporting process to report information about the vibration associated with the rotation of the fan 6.

The reporting process may include, for example, turning on a lamp (not shown) when the vibration is at or above the threshold.

In one alternative example, the lamp may be turned on when the vibration is below the threshold and may blink when the vibration is at or above the threshold.

In a further alternative example, the lamp may blink differently between when the vibration is below the threshold and when the vibration is at or above the threshold. Specifically, for example, when the vibration is below the threshold, the lamp may blink such that the light is turned on for 1 second and then off for 1 second repeatedly, and when the vibration is at or above the threshold, the lamp may blink such that the light is turned on for 1.4 seconds and then off for 0.6 seconds repeatedly.

In a still further alternative example, the reporting process may include presenting, on the display, information indicating that the vibration is at or above the threshold.

In a still further alternative example, the reporting process may include sending, to a terminal used by the relevant user, information indicating that the vibration is at or above the threshold.

The reporting process is not limited to the above examples, and may be any process that reports information about the vibration associated with the rotation of the fan 6 via, for example, sound, light, image or text display, e-mail or other communication means, or any combination thereof.

(Noise suppression)

Similarly to the above process example, noise caused by the fan 6, which is an example of the fan system abnormalities, may be suppressed.

In this process example, noise caused by the fan 6 is suppressed based on a noise characteristic that represents a correlation between the differential pressure characteristic across the filter 13 and the airflow path characteristic in the oil cooling device 10.

The oil cooling device 10 may also perform a reporting process to report information about the noise associated with the rotation of the fan 6 when the estimated noise is at or above a threshold.

In this process example, the control device 20 corrects a relational expression representing the noise characteristic, based on at least one of the temperature Tm of the fan 6 and the rotation speed N of the fan 6, which are the acquired values. Alternatively, the control device 20 identifies a correction value for correcting the results, calculated from the relational expression representing the noise characteristic, to make the results correspond to the fan 6 deformed over time. The control device 20 then provides the corrected relational expression or the identified correction value to the oil cooling device 10.

This helps the oil cooling device 10 to suppress the noise associated with the rotation of the fan 6, regardless of whether or not the fan 6 has been deformed over time.

Alternatively, the threshold may be corrected to correspond to the fan 6 that has been deformed over time.

(Monitoring of fan system component abnormalities)

A process for monitoring any abnormalities in fan system components, which are an example of the fan system abnormalities, is now described.

Examples of such fan system component abnormalities include bearing abnormalities in the motor 7, misalignment, damage to a rotor (not shown), damage to the fan 6, adhesion of dirt or other substances to the fan 6, and imbalance of the fan 6 and the motor 7.

In this process example, the oil cooling device 10 detects an abnormality in a fan system component based on a physical quantity(ies) that is correlated to the abnormality in the fan system component.

Examples of physical quantities correlated to an abnormality in a fan system component include the deceleration time Ti of the fan 6, the driving power W for the motor 7, the rotation speed N of the fan 6, the degree of disturbance, and current order components.

The driving power W for the motor 7 refers to a combined amount of the product of current and voltage. In the case of, e.g., a three-phase AC circuit, the driving power W is a combined amount of the product of phase voltage, phase current, and power factor.

The current order components refer to respective order components for each n-th order frequency, which is n times the frequency of the fundamental wave. For example, the current order components are respective order components based on the phase current supplied to the motor 7. The first order frequency (primary frequency) refers to the frequency of the fundamental wave.

Here, an imbalance of the fan 6 and the motor 7 as an example of the fan system component abnormalities is described.

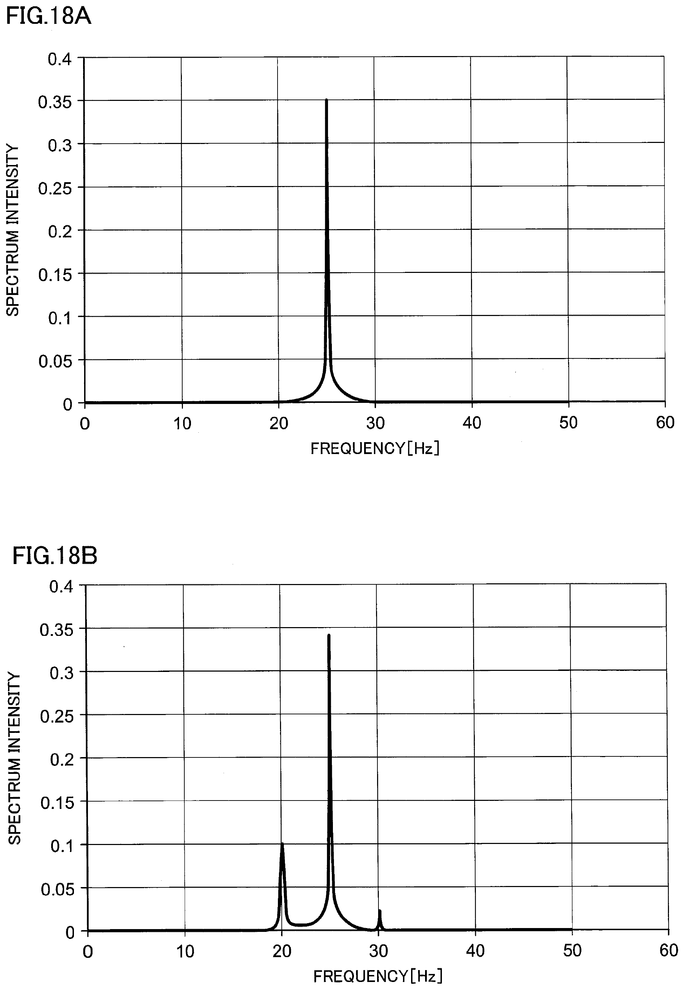

FIGS. 18A and 18B show the results of a frequency analysis of phase currents supplied to the motor 7, where FIG. 18A shows each order component when the fan 6 and the motor 7 are in balance, and FIG. 18B shows each order component when the fan 6 and the motor 7 are out of balance.

FIGS. 18A and 18B show example results of a frequency analysis of each waveform of the phase currents supplied to the motor 7 using the Fast Fourier Transform (FFT). In FIGS. 18A and 18B, the horizontal axis represents the frequency [Hz], and the vertical axis represents the spectrum intensity at each frequency.

In the example shown in FIG. 18A, the fan 6 and the motor 7 are in balance, and the spectrum exists only at the primary frequency of 25 [Hz].

On the other hand, in the example shown in FIG. 18B, the fan 6 and the motor 7 are out of balance and a so-called imbalance is occurring, so that there are two spectra at 20 [Hz] and 30 [Hz], in addition to the spectrum at the primary frequency. These two additional spectra indicate the frequencies of the sideband waves.

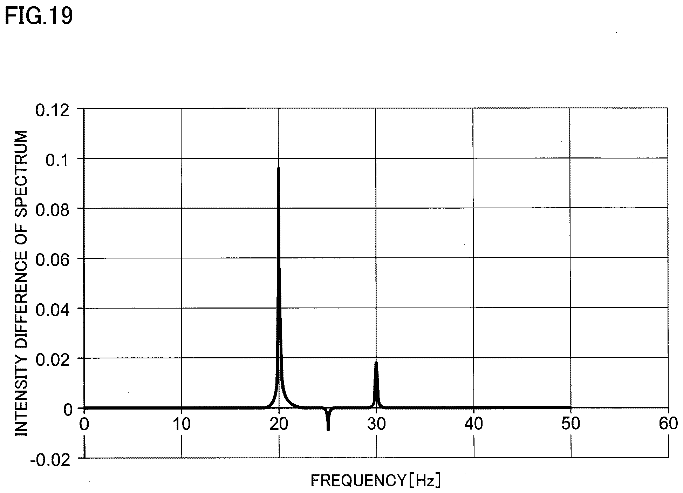

FIG. 19 shows the intensity difference between the spectra.

By way of example, FIG. 19 shows the difference between the results of the frequency analysis of the phase currents supplied to the motor 7 when the fan 6 and the motor 7 are in balance (see FIG. 18A) and when the fan 6 and the motor 7 are out of balance (see FIG. 18B).

The spectrum associated with the primary frequency exists both when the fan 6 and the motor 7 are in balance and when the fan 6 and the motor 7 are out of balance. At the primary frequency, there is little change in the spectrum intensity.

On the other hand, the spectra associated with the frequencies of the sideband waves do not exist when the fan 6 and the motor 7 are in balance, but exist when the fan 6 and the motor 7 are out of balance. Thus, there is a larger difference in spectral intensity at the frequencies of the sideband waves, 20 [Hz] and 30 [Hz], than at 25 [Hz].

The oil cooling device 10 detects an imbalance of the fan 6 and the motor 7 when there is a difference from the spectral intensity observed when the fan 6 and the motor 7 are in balance, as shown in FIG. 19. In other words, the oil cooling device 10 detects an imbalance of the fan 6 and the motor 7 when a current order component is detected that is different from the current order component observed when the fan 6 and the motor 7 are in balance.

The oil cooling device 10 detects an imbalance of the fan 6 and the motor 7 based on a balance characteristic that represents a correlation between the current order components and the imbalance of the fan 6 and the motor 7.

Upon detecting the imbalance of the fan 6 and the motor 7, the oil cooling device 10 may perform a reporting process to report information about this imbalance.

In this case, the control device 20 corrects a relational expression representing the balance characteristic, based on at least one of the temperature Tm of the fan 6 and the rotation speed N of the fan 6, which are the acquired values. Alternatively, the control device 20 identifies a correction value for correcting the results, calculated from the relational expression representing the balance characteristic, to make the results correspond to the fan 6 deformed over time. The control device 20 then provides the corrected relational expression or the identified correction value to the oil cooling device 10.

This helps the oil cooling device 10 to detect an imbalance of the fan 6 and the motor 7, regardless of whether or not the fan 6 has been deformed over time.

Fifth Embodiment

In the above examples, the oil cooling device 10 for cooling the oil uses the correlated information about the fan 6 estimated by the control device 20 of the present disclosure. However, this implementation is not limiting. The correlated information about the fan 6 estimated by the control device 20 of the present disclosure may be used by, for example, a refrigeration apparatus (not shown) for cooling an object different from oil, such as a liquid or air.

A refrigeration apparatus as an example of the fan system includes a fan system including the fan 6 and the motor 7, a flow path through which air is delivered by the fan 6, and the condenser 2 installed in the flow path. In this case, the temperature of the fan 6 of the refrigeration apparatus is estimated based on at least one of the temperature around the fan 6 and the temperature of the condenser 2.

(Estimation of refrigeration efficiency)

A process for estimating refrigeration efficiency Rc of the refrigeration apparatus according to the fifth embodiment is now described. In other words, a process for predicting refrigeration efficiency Rc of the refrigeration apparatus according to the fifth embodiment is described.

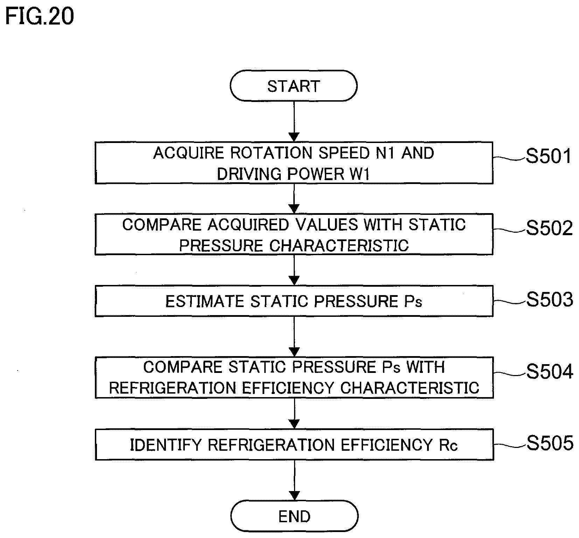

FIG. 20 is a flowchart showing a process flow for controlling the refrigeration efficiency Rc by the fan 6.

FIG. 20 shows an example where the refrigeration efficiency by the fan 6 is estimated based on a refrigeration efficiency characteristic that represents a correlation between the static pressure Ps of fan 6 and the refrigeration efficiency of the refrigeration apparatus.

The refrigeration efficiency characteristic is an example of the fan characteristic, and represents a relationship between a physical quantity(ies) correlated to the refrigeration efficiency Rc of a refrigeration apparatus including a fan system, and the refrigeration efficiency Rc of the refrigeration apparatus.

The refrigeration apparatus acquires the rotation speed N1 of the fan 6 and the driving power W1 for the motor 7 as acquired values (S501).

Physical quantities correlated to the static pressure Ps are not limited to the rotation speed N1 of the fan 6 and the driving power W1 for the motor 7, but also include, for example, the deceleration time Ti of the fan 6, the degree of disturbance, and current order components. Physical quantities correlated to the static pressure Ps are also correlated to the refrigeration efficiency Rc.

Next, the refrigeration apparatus compares the acquired values with the static pressure characteristic of the fan 6 (S502).

The refrigeration apparatus estimates the static pressure Ps based on the acquired values and the static pressure characteristic of the fan 6 (S503). Specifically, the refrigeration apparatus estimates the static pressure Ps across the fan 6, based on the static pressure characteristic passing through the intersection of the rotation speed N1 and the driving power W1.

The static pressure Ps across the fan 6 increases when the filter 13 is clogged. If the refrigeration apparatus has acquired the deceleration time Ti of the fan 6, the refrigeration apparatus may estimate the static pressure Ps across the fan 6 from the deceleration time Ti and the pressure loss index z based on the pressure loss characteristic.

The refrigeration apparatus then compares the static pressure Ps across the fan 6 with the refrigeration efficiency characteristic (S504).

The refrigeration apparatus identifies the refrigeration efficiency Rc based on the estimated static pressure Ps and the refrigeration efficiency characteristic (S505), and terminates the process. In other words, the refrigeration apparatus estimates the refrigeration efficiency Rc based on the estimated static pressure Ps and the refrigeration efficiency characteristic, and terminates the process.

If the estimated refrigeration efficiency Rc is below a threshold, the refrigeration apparatus may perform a reporting process to report the deterioration in refrigeration efficiency of the refrigeration apparatus.

In this process example, the control device 20 corrects a relational expression representing the static pressure characteristic of the fan 6, based on at least one of the temperature Tm of the fan 6 and the rotation speed N of the fan 6, which are the acquired values. Alternatively, the control device 20 identifies a correction value for correcting the results, calculated from the relational expression representing the static pressure characteristic of the fan 6, to make the results correspond to the fan 6 deformed over time. The control device 20 then provides the corrected relational expression or the identified correction value to the refrigeration apparatus.

This helps monitor deterioration in refrigeration efficiency of the refrigeration apparatus caused by clogging of the filter 13, regardless of whether or not the fan 6 has been deformed over time.

Alternatively, the threshold may be corrected to correspond to the fan 6 deformed over time.

(Estimation of cooling capacity)

Similarly to the above process example, the cooling capacity of the refrigeration apparatus according to the fifth embodiment may be estimated.

In this process example, the maximum cooling capacity of the refrigeration apparatus is estimated based on a cooling capacity characteristic that represents a correlation between the static pressure Ps of the fan 6 and the cooling capacity of the refrigeration apparatus. In other words, in this process example, the maximum cooling capacity of the refrigeration apparatus is predicted based on a cooling capacity characteristic that represents a correlation between the static pressure Ps of the fan 6 and the cooling capacity of the refrigeration apparatus.

The cooling capacity characteristic is an example of the fan characteristic, and represents a relationship between a physical quantity(ies) correlated to the cooling capacity of a refrigeration apparatus including with a fan system, and the cooling capacity of the refrigeration apparatus.

The refrigeration apparatus may also perform a reporting process to report information about the estimated maximum cooling capacity of the refrigeration apparatus. Specifically, the refrigeration apparatus may perform a reporting process to report the degradation of the maximum cooling capacity of the refrigeration apparatus.

In this process example, too, the control device 20 corrects the relational expression representing the static pressure characteristic of the fan 6, based on at least one of the temperature Tm of the fan 6 and the rotation speed N of the fan 6, which are the acquired values. Physical quantities correlated to the static pressure Ps are also correlated to the cooling capacity.

Alternatively, the control device 20 identifies a correction value for correcting the results, calculated from the relational expression representing the static pressure characteristic of the fan 6, to make the results correspond to the fan 6 deformed over time. The control device 20 then provides the corrected relational expression or the identified correction value to the refrigeration apparatus.

This helps monitor the degradation of the cooling capacity of the refrigeration apparatus, regardless of whether or not the fan 6 has been deformed over time.

In the present disclosure, the control device 20 is configured to generate the correlated information used for controlling the operation of the oil cooling device 10 or the like. However, this implementation is not limiting.

For example, the oil cooling device 10 may have the functions of the control device 20. Specifically, the oil cooling device 10 may have the functions of the deformation estimation unit 21, the characteristic estimation unit 22, and other units shown in FIG. 6.

The above embodiments can be described as having the following aspects.

According to an aspect of the present disclosure, the characteristic estimation unit 22 of the control device 20 corrects correlated information, correlated to a fan characteristic, to make it correspond to changes in the fan characteristic occurring as a function of deformation over time of the fan.

According to this aspect, the corrected correlated information is stored in the fan characteristic DB 82 in the oil cooling device 10. Based on the corrected correlated information, processes by the drive control unit 83, the pressure loss estimation unit 85, and the clogging determination unit 86 are executed to control the fan system. This allows for controlling the fan system by taking into account changes in the fan characteristic occurring as a function of deformation over time of the fan 6.

The fan system in the clean room 210 or the refrigeration apparatus, instead of the one in the oil cooling device 10, may be controlled based on the corrected correlated information.

The characteristic estimation unit 22 corrects the correlated information based on at least one of the temperature Tm of the fan 6 and the rotation speed N of the fan 6.

With this feature, the fan system is controlled by the oil cooling device 10 based on the corrected correlated information. This allows for controlling the fan system by taking into account changes in the fan characteristic based on at least one of the temperature Tm of the fan 6 and the rotation speed N of the fan 6.

The fan system in the clean room 210 or the refrigeration apparatus, instead of the one in the oil cooling device 10, may be controlled based on the corrected correlated information.

In cases where the characteristic estimation unit 22 controls the airflow Q of the fan 6 based on a correlation between at least one of the driving power W for the motor 7, the rotation speed N of the motor 7, and the static pressure Ps of the fan 6 and the airflow Q of the fan 6, the fan characteristic represents this correlation.

Specifically, in cases where the characteristic estimation unit 22 corrects the correlated information based on at least one of the temperature Tm of the fan 6 and the rotation speed N of the fan 6, which are the acquired values, and the airflow Q is controlled based on the corrected correlated information, the fan characteristic represents the correlated information about the airflow Q.

With this feature, the airflow Q of the fan 6 can be controlled by taking into account changes in the fan characteristic based on at least one of the driving power W for the motor 7, the rotation speed N of the motor 7, and the static pressure Ps of the fan 6.

In cases where the characteristic estimation unit 22 monitors the static pressure Ps of the fan 6 based on a correlation between a physical quantity(ies) correlated to the static pressure Ps of the fan 6 and the static pressure Ps of the fan 6, the fan characteristic represents this correlation.

Specifically, in cases where the characteristic estimation unit 22 corrects the correlated information based on at least one of the temperature Tm of the fan 6 and the rotation speed N of the fan 6, which are the acquired values, and the static pressure Ps is monitored based on the corrected correlated information, the fan characteristic represents the correlated information about the static pressure Ps.

With this feature, the static pressure Ps of the fan 6 can be controlled by taking into account changes in the fan characteristic based on the physical quantity(ies) correlated to the static pressure Ps of the fan 6.

In cases where the characteristic estimation unit 22 monitors a fan system abnormality based on a correlation between a physical quantity(ies) correlated to the fan system abnormality and the fan system abnormality, the fan characteristic represents this correlation.

Specifically, in cases where the characteristic estimation unit 22 corrects the correlated information based on at least one of the temperature Tm of the fan 6 and the rotation speed N of the fan 6, which are the acquired values, and the fan system abnormality is monitored based on the corrected correlated information, the fan characteristic represents the correlated information about the fan system abnormality.

With this feature, the fan system abnormality can be monitored by taking into account changes in the fan characteristic based on the physical quantity(ies) correlated to the fan system abnormality.

The fan system abnormality is vibration or noise of the fan system.

In this case, the fan system abnormality, which is vibration or noise of the fan system, can be monitored by taking into account changes in the fan characteristic.

In cases where the characteristic estimation unit 22 predicts the refrigeration efficiency Rc of a refrigeration apparatus based on a correlation between a physical quantity(ies) correlated to the refrigeration efficiency Rc of the refrigeration apparatus including a fan system and the refrigeration efficiency Rc of the refrigeration apparatus, the fan characteristic represents this correlation.

Specifically, in cases where the characteristic estimation unit 22 corrects the correlated information based on at least one of the temperature Tm of the fan 6 and the rotation speed N of the fan 6, which are the acquired values, and the refrigeration efficiency Rc is predicted based on the corrected correlated information, the fan characteristic represents the correlated information about the refrigeration efficiency Rc.

With this feature, the refrigeration efficiency Rc can be monitored by taking into account changes in the fan characteristic based on the physical quantity(ies) correlated to the refrigeration efficiency Rc.

In cases where the characteristic estimation unit 22 predicts the cooling capacity of a refrigeration apparatus based on a correlation between a physical quantity(ies) correlated to the cooling capacity of the refrigeration apparatus including a fan system and the cooling capacity of the refrigeration apparatus, the fan characteristic represents this correlation.

Specifically, in cases where the characteristic estimation unit 22 corrects the correlated information based on at least one of the temperature Tm of the fan 6 and the rotation speed N of the fan 6, which are the acquired values, and the cooling capacity is predicted based on the corrected correlated information, the fan characteristic represents the correlated information about the cooling capacity.

With this feature, the cooling capacity can be monitored by taking into account changes in the fan characteristic based on the physical quantity(ies) correlated to the cooling capacity.

Viewed from another aspect, the characteristic estimation unit 22 of the control device 20 of the present disclosure controls the fan system based on the history of a physical quantity(ies) correlated to the temperature Tm of the fan 6.

According to this aspect, the correlated information generated by the control device 20 through learning of the history of a physical quantity(ies) correlated to the temperature Tm of the fan 6 is stored in the fan characteristic DB 82 in the oil cooling device 10. This allows for controlling the fan system by taking into account changes in the fan characteristic based on the history of the physical quantity(ies) correlated to the temperature Tm of the fan 6.

The characteristic estimation unit 22 estimates the temperature Tm of the fan 6 of a refrigeration apparatus including a fan system, a flow path through which air flowing by rotation of the fan 6 is delivered, and a condenser 2 installed in the flow path, based on at least one of the temperature around the fan 6 and the temperature of the condenser 2.

With this feature, the temperature Tm of the fan 6 can be acquired without actually measuring the temperature Tm itself.

The temperature estimation unit 84 may estimate the temperature Tm of the fan 6 based on at least one of the temperature around the fan 6 and the temperature of the condenser 2, and provide information about the temperature Tm of the fan 6 to the control device 20.

Viewed from still another aspect, a computer program for the control device 20 of the present disclosure includes instructions that cause the control device 20 configured to control the fan system of the oil cooling device 10 to execute functions of: storing correlated information correlated to a fan characteristic in the fan characteristic DB 24; providing the correlated information to the oil cooling device 10 to control the fan system; and implementing the characteristic estimation unit 22 configured to correct the correlated information to correspond to changes in the fan characteristic occurring as a function of deformation over time of the fan 6.

This allows for controlling the fan system by taking into account changes in the fan characteristic occurring as a function of deformation over time of the fan 6.

The fan system in the clean room 210 or the refrigeration apparatus, as well as the one in the oil cooling device 10, may be controlled based on the corrected correlated information.

It should be noted that the configurations described above are not limited to the above embodiments and can be modified without departing from the spirit of the present disclosure. In other words, it will be understood that various modifications can be made to the forms and details without departing from the sprit and scope of the appended claims.

The present disclosure is not limited to the configurations described above; part of the configurations described above may be omitted, or other features may be added to the configurations described above.

Reference Signs List

2 Condenser
6 Fan
7 Motor
8 Computer
10 Oil cooling device
13 Filter
20, 220 Control device
21 Deformation estimation unit
22 Characteristic estimation unit
23, 87 Communication processing unit
24, 82 Fan characteristic DB
81 Operation record DB
83 Drive control unit
84 Temperature estimation unit
85 Pressure loss estimation unit
86 Clogging determination unit
110 Control unit

**Claims**

1. A control device comprising:

   a control unit configured to control a fan system including a fan and a motor for driving the fan, wherein
   the control unit includes a fan characteristic storage unit configured to store correlated information correlated to a fan characteristic, the fan characteristic being a characteristic of the fan,
   the control unit controls the fan system based on the correlated information, and
   the control unit includes a correction unit configured to correct the correlated information to correspond to changes in the fan characteristic occurring as a function of deformation over time of the fan.

2. The control device according to claim 1, wherein

   the control unit acquires a value of at least one of an ambient temperature of the fan and a rotation speed of the fan, and
   the control unit corrects the correlated information based on the acquired value.

3. The control device according to claim 1 or 2, wherein, in cases where the control unit controls an airflow of the fan based on a relationship between at least one of driving power for the motor, the rotation speed of the fan, and a static pressure of the fan and the airflow of the fan, the fan characteristic represents the relationship.

4. The control device according to claim 1 or 2, wherein, in cases where the control unit acquires a physical quantity correlated to a static pressure of the fan and monitors the static pressure of the fan based on a relationship between the physical quantity and the static pressure of the fan, the fan characteristic represents the relationship.

5. The control device according to claim 1 or 2, wherein, in cases where the control unit acquires a physical quantity correlated to an abnormality in the fan system and monitors the abnormality in the fan system based on a relationship between the physical quantity and the abnormality in the fan system, the fan characteristic represents the relationship.

6. The control device according to claim 5, wherein the abnormality in the fan system is vibration or noise of the fan system.

7. The control device according to claim 1 or 2, wherein, in cases where the control unit acquires a physical quantity correlated to refrigeration efficiency of a refrigeration apparatus including the fan system and predicts the refrigeration efficiency of the refrigeration apparatus based on a relationship between the physical quantity and the refrigeration efficiency of the refrigeration apparatus, the fan characteristic represents the relationship.

8. The control device according to claim 1 or 2, wherein, in cases where the control unit acquires a physical quantity correlated to cooling capacity of a refrigeration apparatus including the fan system and predicts the cooling capacity of the refrigeration apparatus based on a relationship between the physical quantity and the cooling capacity of the refrigeration apparatus, the fan characteristic represents the relationship.

9. A control device comprising:

   a control unit configured to control a fan system including a fan and a motor for driving the fan, wherein
   the control unit acquires a physical quantity correlated to an ambient temperature of the fan, and
   the control unit controls the fan system based on a history of the acquired physical quantity.

10. The control device according to claim 9, wherein the control unit estimates the ambient temperature of the fan of a refrigeration apparatus including the fan system, a flow path through which a fluid is delivered by the fan, and a heat exchanger installed in the flow path, based on at least one of a temperature around the fan and a temperature of the heat exchanger.

11. A computer program comprising instructions that, when executed by a computer configured to control a fan system including a fan and a motor for driving the fan, cause the computer to execute functions of:

   storing correlated information correlated to a fan characteristic, the fan characteristic being a characteristic of the fan;
   controlling the fan system based on the correlated information; and
   implementing a correction unit configured to correct the correlated information to correspond to changes in the fan characteristic occurring as a function of deformation over time of the fan.

FIG.1

EP 4 596 887 A1

FIG.2

10,20

110

110a
CPU

110b
RAM

110c
ROM

110d
NONVOLATILE MEMORY

110e
INTERFACE UNIT

120
SECONDARY STRAGE UNIT

130
COMMUNICATION UNIT

# FIG.3

8

| | |
|---|---|
| OPERATION RECORD DB | 81 |
| FAN CHARACTERISTIC DB | 82 |
| DRIVE CONTROL UNIT | 83 |
| TEMPERTURE ESTIMATION UNIT | 84 |
| PRESSURE LOSS ESTIMATION UNIT | 85 |
| CLOGGING DETERMINATION UNIT | 86 |
| COMMUNICATION PROCESSING UNIT | 87 |

FIG.4A

FIG.4B

# FIG.5

□ WHEN FILTER IS NOT CLOGGED

● WHEN FILTER IS CLOGGED

Vertical axis: ROTATION SPEED N[rpm]

Horizontal axis: DECELERATION TIME Ti[sec] (DEGREE OF DECELERATION)

EP 4 596 887 A1

FIG.6

20

DEFORMATION
ESTIMATION UNIT — 21

CHARACTERISTIC
ESTIMATION UNIT — 22

COMMUNICATION
PROCESSING UNIT — 23

FAN
CHARACTERISTIC DB — 24

FIG.7

6a

6b

Δ8mm

FIG.8

FIG.9A

FIG.9B

## FIG.10

```
        ┌──────────────┐
        │    START     │
        └──────────────┘
                │
                ▼
   ┌────────────────────────────┐
   │  COMMAND GIVEN AIRFLOW Q   │──S101
   └────────────────────────────┘
                │
                ▼
   ┌──────────────────────────────────────────┐
   │ ACQUIRE ROTATION SPEED N AND DRIVING POWER W │──S102
   └──────────────────────────────────────────┘
                │
                ▼
   ┌──────────────────────────────────────────────┐
   │ COMPARE ACQUIRED VALUES WITH AIRFLOW CHARACTERISTIC │──S103
   └──────────────────────────────────────────────┘
                │
                ▼
   ┌──────────────────────────┐
   │     ESTIMATE AIRFLOW Q   │──S104
   └──────────────────────────┘
                │
                ▼
   ┌────────────────────────────────────────────────────┐
   │ COMPARE COMMANDED AIRFLOW Q WITH ESTIMATED AIRFLOW Q │──S105
   └────────────────────────────────────────────────────┘
                │
                ▼
              S106
         ◇ IS ABSOLUTE VALUE
     OF DIFFERENCE BETWEEN COMMANDED      NO
     AIRFLOW Q AND ESTIMATED AIRFLOW Q ────────┐
        LESS THAN PREDETERMINED               │
              VALUE? ◇                        │
                │                             ▼       S107
               YES              ┌──────────────────────────────┐
                │               │ INCREASE OR DECREASE ROTATION │
                ▼               │ SPEED N ACCORDING TO DIFFERENCE│
        ┌──────────────┐        │ BETWEEN COMMANDED AIRFLOW Q AND│
        │     END      │        │    ESTIMATED AIRFLOW Q        │
        └──────────────┘        └──────────────────────────────┘
```

FIG.11

## FIG.12

```
           ┌─────────────┐
           │    START    │
           └──────┬──────┘
                  │
                  ▼
  ┌───────────────────────────────────┐
  │   ACQUIRE DECELERATION TIME Ti     │────S201
  └───────────────┬───────────────────┘
                  │
                  ▼
  ┌───────────────────────────────────┐
  │ COMPARE ACQUIRED VALUE WITH PRESSURE│────S202
  │        LOSS CHARACTERISTIC         │
  └───────────────┬───────────────────┘
                  │
                  ▼
  ┌───────────────────────────────────┐
  │   ESTIMATE PRESSURE LOSS INDEX z   │────S203
  └───────────────┬───────────────────┘
                  │
                  ▼
  ┌───────────────────────────────────┐
  │  DETERMINE CLOGGING BASED ON THRESHOLD│────S204
  └───────────────┬───────────────────┘
                  │
                  ▼
  ┌───────────────────────────────────┐
  │           REPORT CLOGGING          │────S205
  └───────────────┬───────────────────┘
                  │
                  ▼
           ┌─────────────┐
           │     END     │
           └─────────────┘
```

FIG.13

FIG.14

EP 4 596 887 A1

FIG.15

```
                    ┌─────────────┐
                    │    START    │
                    └──────┬──────┘
                           │
                           ▼
        ┌──────────────────────────────────────┐
        │ COMMAND GIVEN STATIC PRESSURE Ps      │──S301
        └──────────────────┬───────────────────┘
                           │
                           ▼
        ┌──────────────────────────────────────┐
        │ ACQUIRE ROTATION SPEED N AND DRIVING POWER W │──S302
        └──────────────────┬───────────────────┘
                           │
                           ▼
        ┌──────────────────────────────────────┐
        │ COMPARE ACQUIRED VALUES WITH STATIC   │──S303
        │ PRESSURE CHARACTERISTIC               │
        └──────────────────┬───────────────────┘
                           │
                           ▼
        ┌──────────────────────────────────────┐
        │ ESTIMATE STATIC PRESSURE Ps           │──S304
        └──────────────────┬───────────────────┘
                           │
                           ▼
        ┌──────────────────────────────────────┐
        │ COMPARE COMMANDED STATIC PRESSURE Ps  │──S305
        │ WITH ESTIMATED STATIC PRESSURE Ps     │
        └──────────────────┬───────────────────┘
                           │
                           ▼
```

IS ABSOLUTE VALUE OF DIFFERENCE BETWEEN COMMANDED STATIC PRESSURE Ps AND ESTIMATED STATIC PRESSURE Ps LESS THAN PREDETERMINED VALUE ?   S306

NO   S307

INCREASE OR DECREASE ROTATION SPEED N ACCORDING TO DIFFERENCE BETWEEN COMMANDED STATIC PRESSURE Ps AND ESTIMATED STATIC PRESSURE Ps

YES

END

## FIG.16

```
        ┌─────────────┐
        │    START    │
        └──────┬──────┘
               ↓
┌──────────────────────────────────────────────┐
│ ACQUIRE ROTATION SPEED N1 AND DRIVING POWER W1│──S401
└──────────────────────┬───────────────────────┘
               ↓
┌──────────────────────────────────────────────┐
│ COMPARE ACQUIRED VALUES WITH VIBRATION        │──S402
│ CHARACTERISTIC                                │
└──────────────────────┬───────────────────────┘
               ↓
┌──────────────────────────────────────────────┐
│           ESTIMATE VIBRATION S                │──S403
└──────────────────────┬───────────────────────┘
               ↓
┌──────────────────────────────────────────────┐
│ DETERMINE WHETHER TO AVOID VIBRATION          │──S404
│ BASED ON THRESHOLD                            │
└──────────────────────┬───────────────────────┘
               ↓
┌──────────────────────────────────────────────┐
│ IDENTIFY ROTATION SPEED N TO AVOID VIBRATION  │──S405
└──────────────────────┬───────────────────────┘
               ↓
┌──────────────────────────────────────────────┐
│           COMMAND ROTATION SPEED N            │──S406
└──────────────────────┬───────────────────────┘
               ↓
        ┌─────────────┐
        │     END     │
        └─────────────┘
```

FIG.17A

FIG.17B

## FIG.18A

## FIG.18B

FIG.19

# FIG.20

START

ACQUIRE ROTATION SPEED N1 AND DRIVING POWER W1 — S501

COMPARE ACQUIRED VALUES WITH STATIC PRESSURE CHARACTERISTIC — S502

ESTIMATE STATIC PRESSURE Ps — S503

COMPARE STATIC PRESSURE Ps WITH REFRIGERATION EFFICIENCY CHARACTERISTIC — S504

IDENTIFY REFRIGERATION EFFICIENCY Rc — S505

END

**EP 4 596 887 A1**

## INTERNATIONAL SEARCH REPORT

International application No.

**PCT/JP2023/028274**

### A. CLASSIFICATION OF SUBJECT MATTER

*F04D 27/00*(2006.01)i
FI: F04D27/00 A; F04D27/00 H

According to International Patent Classification (IPC) or to both national classification and IPC

### B. FIELDS SEARCHED

Minimum documentation searched (classification system followed by classification symbols)

F04D27/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2015/162648 A1 (FUJI ELECTRIC CO., LTD.) 29 October 2015 (2015-10-29) paragraphs [0023]-[0027], [0033]-[0035], fig. 3-4 | 1-11 |

☐ Further documents are listed in the continuation of Box C.  ☑ See patent family annex.

| | |
|---|---|
| * Special categories of cited documents: <br> "A" document defining the general state of the art which is not considered to be of particular relevance <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| **05 October 2023** | **17 October 2023** |

| Name and mailing address of the ISA/JP | Authorized officer |
|---|---|
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (January 2015)

44

**INTERNATIONAL SEARCH REPORT**
Information on patent family members

International application No.

**PCT/JP2023/028274**

| Patent document cited in search report | Publication date (day/month/year) | Patent family member(s) | Publication date (day/month/year) |
|---|---|---|---|
| WO 2015/162648 A1 | 29 October 2015 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5175622 B